# EUROPEAN PATENT APPLICATION

(11) **EP 4 756 566 A1**
(43) Date of publication of application: **10.06.2026**
(21) Application number: 25742282.4
(22) Date of filing: 17.01.2025
(51) Int. Cl.: G06F 1/16, G02B 1/14

(54) **ELECTRONIC DEVICE COMPRISING WINDOW ASSEMBLY AND METHOD FOR MANUFACTURING WINDOW ASSEMBLY**

(30) Priority: 17.01.2024 KR 20240007572; 26.04.2024 KR 20240056056
(71) Applicant: Samsung Electronics Co., Ltd., Suwon-si, Gyeonggi-do 16677 (KR)
(72) Inventor: CAO, Doan Xuan, Bac Ninh province, 220000 (VN); TRINH, Hoai Nam, Bac Ninh province, 220000 (VN)
(74) Representative: Gulde & Partner
(86) International application number: PCT/KR2025/001019
(87) International publication number: WO 2025/155134

(57) **Abstract**

An embodiment of the present disclosure may provide an electronic device. The electronic device may comprise: a housing; a display panel disposed in the housing; and a window assembly disposed on one surface of the display panel, wherein an image output from the display panel is provided to the outside of the electronic device through the window assembly. The window assembly may include: a cover window including a first surface exposed to the outside of the electronic device, a second surface opposite to the first surface, and an edge surface connecting the first surface and the second surface; and a coating layer disposed on a portion of the cover window. The edge surface of the cover window of the window assembly may include a first edge region extending from the first surface, and a second edge region extending from the second surface. The coating layer of the window assembly may be disposed on the first surface of the cover window and on the first edge region of the edge surface.

## Description

### [Technical Field]

Examples disclosed herein relate to an electronic device including a window assembly and a method of manufacturing the window assembly.

### [Background Art]

Due to advancement in information and communication technology and semiconductor technology, various functions are being integrated into a single portable electronic device. For example, an electronic device may implement not only communication functions, but also entertainment functions, such as gaming, multimedia functions, such as music/video playback, communication and security functions for mobile banking, or schedule management and electronic wallet functions. These electronic devices are being miniaturized to be conveniently carried by users.

An electronic device may include a display and a cover window for protecting the display from external physical/chemical impacts. The cover window may be laminated on the front surface of the display and exposed outside the electronic device. One or more coating layers may be provided on the front surface of the cover window to adjust front reflection characteristics and improve optical clarity. The coating layers may be formed to provide functional properties such as transparency, scratch resistance, and wear resistance.

The above-described information may be provided as related art for the purpose of assisting in understanding the disclosure. No assertion or decision is made as to whether any of the above might be applicable as prior art with regard to the disclosure.

### [Detailed Description of the Invention]

### [Technical Solution]

Aspects of the disclosure are to address at least the above-mentioned problems and/or disadvantages and to provide at least the advantages described below. Accordingly, an aspect of the disclosure is to provide an electronic device including a window assembly and a method of manufacturing the window assembly.

Additional aspects will be set forth in part in the description which follows and, in part, will be apparent from the description, or may be learned by practice of the presented embodiments.

An embodiment of the disclosure may provide an electronic device. The electronic device may include a housing, a display panel disposed within the housing, and a window assembly disposed on one surface of the display panel, wherein an image output from the display panel is provided outside the electronic device through the window assembly. The window assembly may include a cover window including a first surface exposed outside the electronic device, a second surface opposite to the first surface, and an edge surface connecting the first surface and the second surface, and a coating layer disposed on a portion of the cover window. The edge surface of the cover window of the window assembly may include a first edge area extending from the first surface and a second edge area extending from the second surface. The coating layer of the window assembly may be disposed on the first surface of the cover window and the first edge area of the edge surface.

According to an embodiment of the disclosure, it may be possible to provide a method of manufacturing a window assembly of an electronic device. The manufacturing method may include preparing a cover window, introducing an adhesive member to the cover window, curing the adhesive member to couple it to the cover window, forming a coating layer on a portion of the cover window, and removing the cured adhesive member.

Other aspects, advantages, and salient features of the disclosure will become apparent to those skilled in the art from the following detailed description, which, taken in conjunction with the annexed drawings, discloses various embodiments of the disclosure.

### [Brief Description of Drawings]

The above and other aspects, features, and/or advantages of an embodiment of the disclosure will be more apparent from the following detailed description taken in conjunction with the accompanying drawings.
FIG. 1 is a block diagram of an electronic device according to an embodiment of the disclosure in a network environment.
FIG. 2 is a front perspective view illustrating an electronic device according to an embodiment of the disclosure.
FIG. 3 is a rear perspective view illustrating the electronic device according to an embodiment of the disclosure.
FIG. 4 is a front exploded perspective view of an electronic device according to an embodiment of the disclosure.
FIG. 5 is a rear exploded perspective view of an electronic device according to an embodiment of the disclosure.
FIG. 6A is a cross-sectional view taken along line A-A' of FIG. 2, according to an embodiment of the disclosure.
FIG. 6B is an enlarged view of part "B" of FIG. 6A, according to an embodiment of the disclosure.
FIG. 7 is a partial cross-sectional side view of a window assembly according to an embodiment of the disclosure.
FIG. 8A is a plan view of a cover window according to an embodiment of the disclosure.
FIG. 8B is a cross-sectional view taken along line C-C' of FIG. 8A, according to an embodiment of the disclosure.
FIG. 9 is a partial cross-sectional side view of a cover window according to an embodiment of the disclosure.
FIG. 10A is a plan view of a fixing member according to an embodiment of the disclosure.
FIG. 10B is a cross-sectional side view of the fixing member taken along line D-D' of FIG. 10A, according to an embodiment of the disclosure.
FIG. 10C is an enlarged view of part E in FIG. 10B, according to an embodiment of the disclosure.
FIG. 11 is a flowchart illustrating a method of manufacturing a window assembly according to an embodiment of the disclosure.
FIG. 12A is a plan view illustrating a fixing member and an adhesive member according to an embodiment of the disclosure.
FIG. 12B is a cross-sectional view taken along line F-F' of FIG. 12A, illustrating the fixing member and the adhesive member according to an embodiment of the disclosure.
FIG. 13A is a plan view illustrating a fixing member, an adhesive member, and a cover window according to an embodiment of the disclosure.
FIG. 13B is a cross-sectional view taken along line I-I' of FIG. 13A, illustrating the fixing member, the adhesive member, and the cover window according to an embodiment of the disclosure.
FIG. 14A is a plan view of a fixing member, an adhesive member, and a window assembly according to an embodiment of the disclosure.
FIG. 14B is a cross-sectional view taken along line J-J' of FIG. 14A, illustrating the fixing member, the adhesive member, and the window assembly according to an embodiment of the disclosure.
FIG. 14C is an enlarged view of part K in FIG. 14B, according to an embodiment of the disclosure.
FIG. 15A is an enlarged view of part H of FIG. 6B, illustrating a housing, a window assembly, and a display panel according to an embodiment of the disclosure.
FIG. 15B is an enlarged view of a portion of FIG. 15A according to an embodiment of the disclosure.
FIG. 16 is an enlarged view of part H of FIG. 6B, illustrating the housing and the window assembly according to an embodiment of the disclosure.
FIG. 17 is an enlarged view of part H of FIG. 6B, illustrating the housing and the window assembly according to an embodiment of the disclosure.
FIG. 18A is a side view of a window assembly according to an embodiment of the disclosure.
FIG. 18B is an enlarged view of part M of FIG. 18A, illustrating the window assembly according to an embodiment of the disclosure.
FIG. 18C is a cross-sectional side view illustrating a fixing member, an adhesive member, and a window assembly according to an embodiment of the disclosure.
FIG. 19A is a cross-sectional side view of a housing, a window assembly, and a display panel according to an embodiment of the disclosure.
FIG. 19B is a cross-sectional side view illustrating a fixing member, an adhesive member, and a window assembly according to an embodiment of the disclosure.
FIG. 20 is a cross-sectional side view illustrating a fixing member, an adhesive member, and a window assembly according to an embodiment of the disclosure.
FIG. 21 is a cross-sectional side view illustrating a fixing member, an adhesive member, and a window assembly according to an embodiment of the disclosure.

Throughout the appended drawings, like reference numerals may be assigned to like components, configurations, and/or structures.

### [Mode for Carrying out the Invention]

The following description with reference to the accompanying drawings is provided to assist in comprehensive understanding of various embodiments of the disclosure as defined by the claims and equivalents thereof. The following description includes various specific details to assist in the understanding, but the details are to be regarded merely as examples. Accordingly, those skill in the art will recognize that various changes and modifications may be made to the various embodiments set forth herein without departing from the scope and spirit of the disclosure. In addition, descriptions of known functions and configurations may be omitted for the sake of clarity and brevity.

The terms and words used in the following description and the claims are not limited to the bibliographical meanings thereof, but are merely used by the inventors to enable clear and consistent understanding of the disclosure. Accordingly, it will be apparent to those skilled in the art that the following description of various embodiments of the disclosure is not intended to limit the disclosure as defined by the appended claims and equivalents thereof, but is provided merely for the purpose of illustration.

It is to be understood that the singular forms "a," "an," and "the" include plural referents unless the context clearly dictates otherwise. Therefore, for example, reference to "a component surface" includes reference to one or more such surfaces.

It should be appreciated that the blocks in each flowchart and combinations of the flowcharts may be performed by one or more computer programs which include computer-executable instructions. The entirety of the one or more computer programs may be stored in a single memory device or the one or more computer programs may be divided with different portions stored in different multiple memory devices.

Any of the functions or operations described herein can be processed by one processor or a combination of processors. The one processor or the combination of processors is circuitry performing processing and includes circuitry like an application processor (AP, e.g., a central processing unit (CPU)), a communication processor (CP, e.g., a modem), a graphical processing unit (GPU), a neural processing unit (NPU) (e.g., an artificial intelligence (AI) chip), a wireless-fidelity (Wi-Fi) chip, a Bluetooth^{™} chip, a global positioning system (GPS) chip, a near field communication (NFC) chip, connectivity chips, a sensor controller, a touch controller, a finger-print sensor controller, a display drive integrated circuit (IC), an audio CODEC chip, a universal serial bus (USB) controller, a camera controller, an image processing IC, a microprocessor unit (MPU), a system on chip (SoC), an IC, or the like.

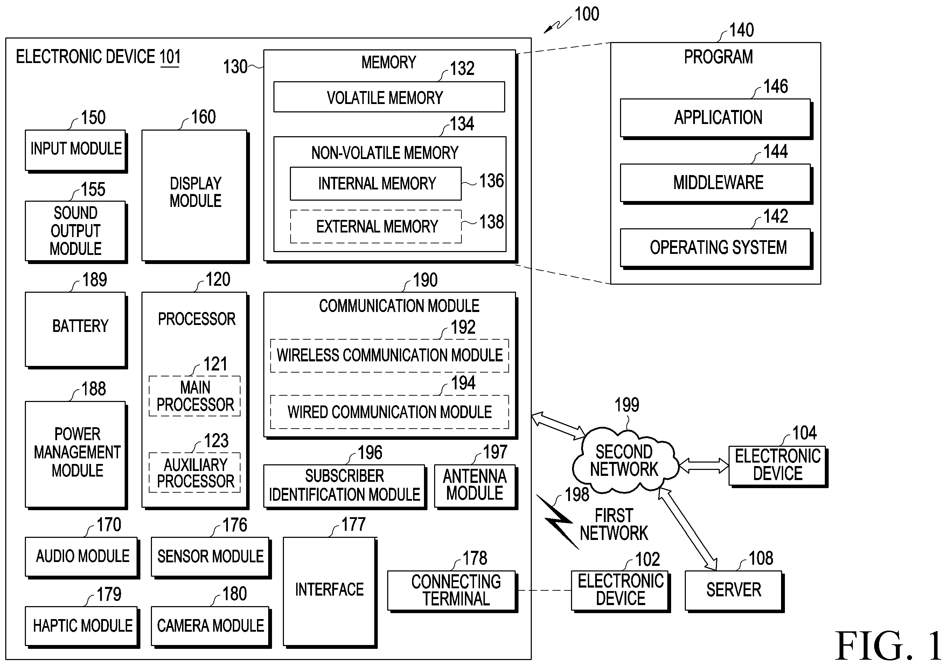

FIG. 1 is a block diagram illustrating an electronic device in a network environment according to this disclosure.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

In the following detailed description, a length direction, a width direction, and/or a thickness direction of an electronic device may be mentioned. The length direction may be defined as the "Y-axis direction", the width direction may be defined as the "X-axis direction", and/or the thickness direction may be defined as the "Z-axis direction". In an embodiment, the direction in which a component is oriented may be mentioned along with the orthogonal coordinate system illustrated in the drawings, as well as the negative/positive symbol "(-/+)". For example, the front surface of an electronic device or a housing may be defined as a "surface oriented in the +Z direction", and the rear surface may be defined as a "surface oriented in the -Z direction". In an embodiment, a side surface of the electronic device or the housing may include an area oriented in the +X direction, an area oriented in the +Y direction, an area oriented in the -X direction, and/or an area oriented in the -Y direction. In another embodiment, the "X-axis direction" may include both the "-X direction" and the "+X direction". It is noted that these are based on the orthogonal coordinate system illustrated in the drawings for the sake of brevity of description, and the description of these directions or components does not limit an embodiment of the disclosure. For example, depending on whether the electronic device is in an unfolded or folded state, the direction in which the aforementioned front or rear surface may vary, and the aforementioned directions may be interpreted differently depending on a user's holding habits.

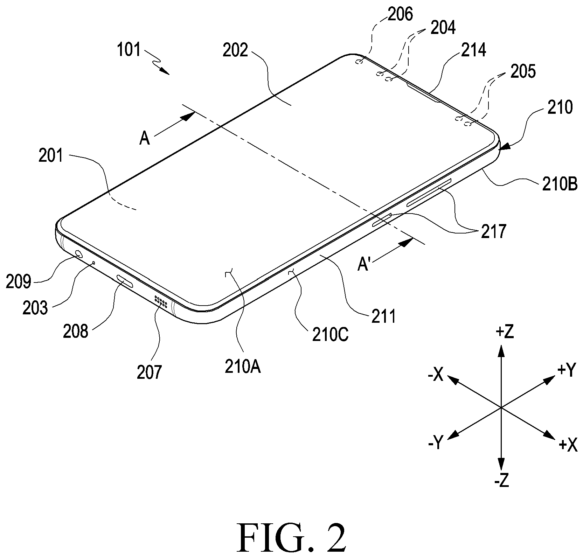

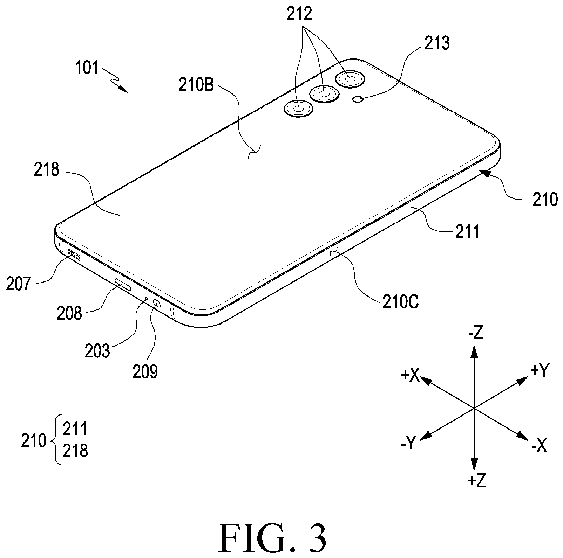

FIG. 2 is a front perspective view of an electronic device according to an embodiment of the disclosure. FIG. 3 is a perspective view illustrating the electronic device of FIG. 2 according to an embodiment of the disclosure, viewed from the rear side. The configuration of the electronic device 101 of FIGS. 2 and 3 may be entirely or partially identical to that of the electronic device 101 of FIG. 1.

Referring to FIGS. 2 and 3, according to an embodiment, the electronic device 101 may include a housing 210 including a first outer surface (or a front surface) 210A(or first surface 210A), a second outer surface (or a rear surface) 210B(or second surface 210B) and a side surface 210C surrounding the space between the first outer surface 210A and the second outer surface 210B. In an embodiment (not illustrated), the housing 210 may refer to a structure that forms some of the first outer surface 210A of FIG. 2, and the second outer surface 210B, and the side surface 210C of FIG. 3. According to an embodiment, at least a part of the first outer surface 210A may be formed by a substantially transparent front surface plate 202 (e.g., a glass plate or a polymer plate including various coating layers). The second outer surface 210B may be formed by a substantially opaque rear surface plate 218. The rear surface plate 218 may be made of, for example, coated or colored glass, ceramic, polymer, metal (e.g., aluminum, stainless steel (STS), or magnesium), or a combination of two or more of these materials. The side surface 210C may be defined by the side surface structure (or a "side surface bezel structure") 211 coupled to the front surface plate 202 and the rear surface plate 218 and including metal and/or polymer. In an embodiment, the rear surface plate 218 and the side surface structure 211 may be integrated with each other and may include the same material (e.g., a metal material such as aluminum).

Although not illustrated, the front surface plate 202 may include one or more areas that are curved and extend seamlessly from at least a portion of an edge toward the rear surface plate 218. In an embodiment, the front surface plate 202 (or the rear surface plate 218) may include only one of the areas bent and extending toward the rear surface plate 218 (or the front surface plate 202), at one side edge of the first outer surface 210A. According to an embodiment, the front surface plate 202 or the rear surface plate 218 may have a substantially flat plate shape, and in this case, may not include a bent and extending area. When the bent and extending area is included, the thickness of the electronic device 101 in the portion including the bent and extending area may be smaller than the thicknesses of other portions.

According to an embodiment, the electronic device 101 may include at least one of a display 201, an audio module (not illustrated) including one or more sound holes 203, 207, and 214 (e.g., the audio module 170 in FIG. 1), a sensor module 204 (e.g., the sensor module 176 in FIG. 1), camera modules 205, 215, and 213 (e.g., the camera module 180 in FIG. 1), key input devices 217 (e.g., the input module 150 in FIG. 1), and connector holes 208 and 209 (e.g., the connection terminal 178 in FIG. 1). In an embodiment, in the electronic device 101, at least one of the components (e.g., the key input devices 217 or the light-emitting element 206) may be omitted, or other components may be additionally included.

According to an embodiment, the display 201 may be visually exposed through a substantial portion of, for example, the front surface plate 202. In an embodiment, at least a portion of the display 201 may be visually exposed through the front surface plate 202 forming the first outer surface 210A or through a portion of the side surface 210C. In an embodiment, the edge of the display 201 may be formed to be substantially the same as the shape of the periphery of the front surface plate 202 adjacent thereto. In an embodiment (not illustrated), the distance between the periphery of the display 201 and the periphery of the front surface plate 202 may be substantially constant in order to enlarge the visually exposed area of the display 201.

In an embodiment (not illustrated), recesses or openings may be provided in a portion of the screen display area (or active area) of the display 201, and one or more of a sound hole 214, the sensor modules 204, the camera modules 205, and the light-emitting elements 206, which are aligned with the recesses or the openings, may be included. In an embodiment (not illustrated), the rear surface of the screen display area of the display 201 may include at least one of the sound hole 214, the sensor modules 204, the camera modules 205, a fingerprint sensor (not illustrated), and the light-emitting elements 206. In an embodiment (not illustrated), the display 201 may be coupled to or arranged adjacent to a touch-sensitive circuit, a pressure sensor capable of measuring a touch intensity (pressure), and/or a digitizer configured to detect an electromagnetic field-type stylus pen. In an embodiment, at least some of the sensor modules 204 and/or at least some of the key input devices 217 may be disposed on the side surface 210C.

According to an embodiment, an audio module (not illustrated) may include a microphone hole 203 and sound holes 207 and 214. A microphone configured to acquire external sound may be placed inside the microphone hole 203, and in an embodiment, a plurality of microphones may be placed to detect the direction of sound. According to an embodiment, the sound holes 207 and 214 may include an external sound hole 207 and a communication receiver hole 214. In an embodiment, the sound holes 207 and 214 and the microphone hole 203 may be implemented as one hole, or a speaker may be included in the audio module without the sound holes 207 and 214 (e.g., a piezo speaker).

According to an embodiment, the sensor modules 204 may generate electrical signals or data values corresponding to an internal operating state or an external environmental state of the electronic device 101. The sensor modules 204 may include, for example, a first sensor module 204 (e.g., a proximity sensor) and/or a second sensor module (not illustrated) (e.g., a fingerprint sensor) disposed on the first outer surface 210A of the housing 210. According to an embodiment, an additional sensor module may be disposed on the second outer surface 210B of the housing 210. The fingerprint sensor (not illustrated) may be disposed not only on the first outer surface 210A (e.g., the display 201) of the housing 210, but also on the second outer surface 210B or the side surface 210C of the housing 210. The electronic device 101 may further include at least one of, for example, a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

According to an embodiment, the camera modules 205, 215, and 213 may include a first camera module 205 facing the first outer surface 210A of the electronic device 101 and a second camera module 215 facing the second outer surface 210B and/or a flash 213. For example, the first camera module 205 and/or the second camera module 215 may include one or more lenses, an image sensor, and/or an image signal processor. According to an embodiment, some camera modules 205 among the camera modules 205 and 215 and/or some sensor modules (e.g., the sensor modules 204) may be disposed to be exposed to the outside through at least a portion of the display 201. According to an embodiment, the first camera modules 205 may include a punch hole camera disposed inside a hole or recess provided in the rear surface of the display 201. For example, the first camera module 205 may receive at least a portion of the light incident on the first outer surface (or front surface) 210A of the electronic device 101 through the display 201 inside the electronic device 101. According to an embodiment, the first camera module 205 and/or the sensor modules 204 may be disposed from the inner space of the electronic device 101 to the front surface plate 202 of the display 201 to come into contact with the outer environment through a transparent area. In addition, some sensor modules 204 may be disposed in the inner space of the electronic device to perform the functions thereof without being visually exposed through the front surface plate 202.

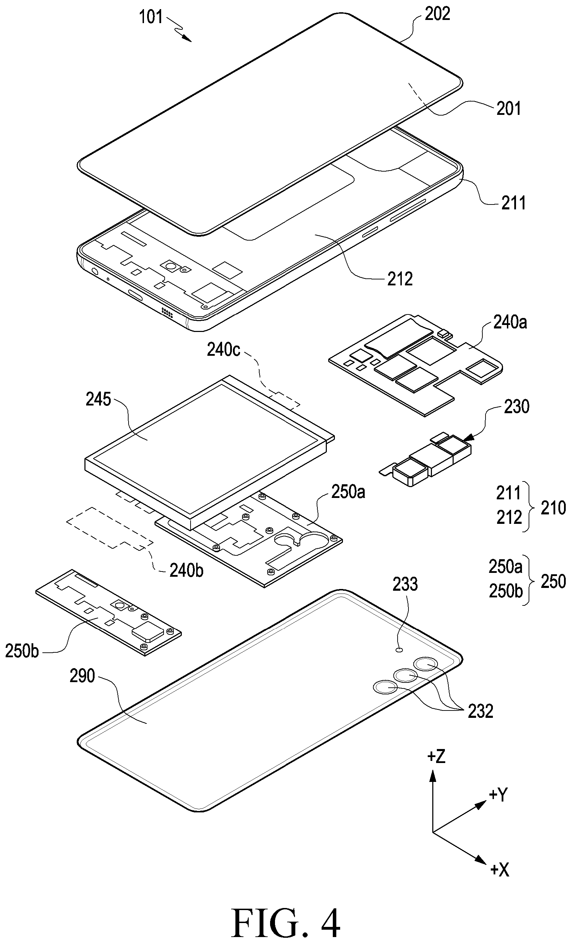

According to an embodiment, the second camera modules 215 may be disposed inside the housing 210 such that a lens is exposed to the second outer surface (or the rear surface) 210B of the electronic device 101. For example, the second camera modules 215 may be electrically connected to a printed circuit board (e.g., the printed circuit board 240a in FIG. 4). For example, the flash 213 may include a light-emitting diode or xenon lamp. In an embodiment, one or more lenses (e.g., an infrared camera lens, a wide-angle lens, and a telephoto lens) and image sensors may be disposed on one surface of the electronic device 101. In an embodiment, the flash 213 may emit infrared rays. For example, the infrared rays emitted from the flash 213 and reflected by an object may be received through a sensor module (not illustrated) disposed on the second outer surface 210B of the housing 210. The electronic device 101 or a processor (e.g., the processor 120 in FIG. 1) may detect depth information of the object based on the point in time when the infrared rays are received from the sensor module.

The camera modules 205, 215, and 213 are not limited to the above-described structure, and may be variously changed in design depending on the structure of the electronic device 101, for example, by mounting only some of the camera modules or by adding new camera modules.

According to an embodiment, the electronic device 101 may include a plurality of camera modules (e.g., a dual camera or a triple camera) having different properties (e.g., fields of view) or functions, respectively. For example, the plurality of camera modules 205 and 215 including lenses having different fields of view may be provided, and the electronic device 101 may control the change of the fields of view of the camera modules 205 and 215 executed therein based on a user's selection. For example, at least one of the plurality of camera modules 205 and 215 may be a wide-angle camera, and at least one of other camera modules may be a telephoto camera. Similarly, at least one of the plurality of camera modules 205 and 215 may be a front camera, and at least one of other camera modules may be a rear camera. In addition, the plurality of camera modules 205 and 215 may include at least one of a wide-angle camera, a telephoto camera, or an infrared (IR) camera (e.g., a time-of-flight (TOF) camera, or a structured light camera). According to an embodiment, the IR camera may be operated as at least a part of a sensor module. For example, the TOF camera may be operated as at least a part of a sensor module (not illustrated) for detecting a distance to an object.

According to an embodiment, the key input device 217 may be disposed on the side surface 210C of the housing 210. In an embodiment, the electronic device 101 may not include some or all of the above-mentioned key input devices 217, and key input devices 217, which are not included, may be implemented in another form, such as soft keys, on the display 201. In an embodiment, the key input devices may include a sensor module disposed on the second outer surface 210B of the housing 210.

According to an embodiment, the light-emitting element 206 may be disposed on, for example, the first outer surface 210A of the housing 210. The light-emitting element 206 may provide, for example, the state information of the electronic device 101 in an optical form. In an embodiment, the light-emitting element 206 may provide, for example, a light source that is linked with the operation of the camera module 205. The light-emitting element 206 may include, for example, a light-emitting diode (LED), an IR LED, and a xenon lamp.

According to an embodiment, the connector holes 208 and 209 may include a first connector hole 208 capable of accommodating a connector (e.g., a USB connector) configured to transmit/receive power and/or data to/from an external electronic device, and a second connector hole (e.g., an earphone jack) 209 capable of accommodating a connector configured to transmit/receive an audio signal to/from an external electronic device.

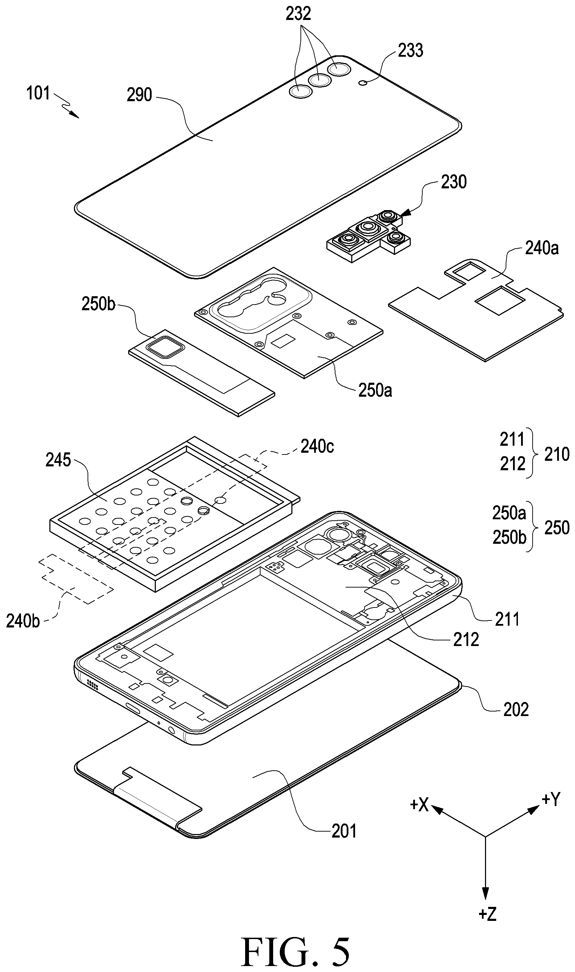

FIG. 4 is a front exploded perspective view of an electronic device according to an embodiment of the disclosure. FIG. 5 is a rear exploded perspective view of the electronic device according to an embodiment of the disclosure.

Referring to FIGS. 4 and 5, the electronic device 101 (e.g., the electronic device 101 in FIG. 1 and/or the electronic device 101 in FIG. 2 or 3) may include a display 201 (e.g., the display 201 in FIG. 2), a front surface plate 202 (e.g., the front surface plate 202 in FIG. 2), a support structure 212 (e.g., a bracket), a side surface bezel structure 222, a camera module 230 (e.g., the camera module 180 in FIG. 1), one or more printed circuit boards (or PCB assemblies) 240a and 240b, a battery 245 (e.g., the battery 189 in FIG. 1), a rear case 250, an antenna (not illustrated) (e.g., the antenna module 197 in FIG. 1), and/or a rear surface plate 290 (e.g., the rear surface plate 218 in FIG. 3). According to an embodiment, when the electronic device 101 includes multiple printed circuit boards 240a and 240b, the electronic device 101 may include at least one flexible printed circuit board 240c to electrically connect different printed circuit boards. For example, the printed circuit boards 240a and 240b may include a first circuit board 240a positioned above the battery 245 (e.g., in the +Y-axis direction) and a second circuit board 240b positioned below the battery 245 (e.g., in the -Y-axis direction), and the flexible printed circuit board 240c may electrically connect the first circuit board 240a and the second circuit board 240b.

According to an embodiment, the electronic device 101 may omit at least one component (e.g., the support structure 212, the rear case 250, or the flexible printed circuit board 240c) or may include additional components. At least one of the components of the electronic device 101 may be the same as or similar to at least one of the components of the electronic device 101 of FIG. 2 or FIG. 3, and a redundant description thereof is omitted below.

In an embodiment, the support structure 212 may be provided in at least a partially planar form. In another embodiment, the support structure 212 may be disposed inside the electronic device 101 and may be either connected to or integrated with the side surface structure 211. For example, the support structure 212 may be made of a conductive material and/or a non-conductive material (e.g., polymer). When the support structure 212 includes a conductive material such as metal, a portion of the side surface structure 211 or the support structure 212 may function as an antenna. The support structure 212 may have two surfaces facing away from each other. The display 201 may be disposed on one of the two surfaces of the support structure 212, while the printed circuit boards 240a and 240b may be disposed on the other surface.

According to an embodiment, the support member 212 and the side surface structure 211 may be combined to be referred to as a front case or a housing 210. According to an embodiment, the housing 210 may be generally understood as a structure to accommodate, protect, or place electrical/electronic components such as printed circuit boards 240a and 240b or a battery 245. In an embodiment, it may be understood that the housing 210 includes structures capable of being visually or tactfully recognized by a user in the exterior of the electronic device 101, such as the side surface structure 211, the front surface plate 202, and/or the rear surface plate 290. In an embodiment, the "front surface or rear surface of the housing 210" may refer to the first surface 210A in FIG. 2 or the second surface 210B in FIG. 3. In an embodiment, the support member 212 may be disposed between the front surface plate 202 (e.g., the first surface 210A in FIG. 2) and the rear surface plate 290 (e.g., the second surface 210B in FIG. 3) and may serve as a structure on which electrical/electronic components, such as the printed circuit boards 240 and 240b or the camera module 230, are disposed. In the following detailed description, the camera module 230 of the electronic device 101 may generally be illustrated as including a configuration that receives light that enters through the second outer surface 210B of the electronic device 101. However, the electronic device 101 may further include a camera module (e.g., the camera module 205 in FIG. 2) and/or a sensor module (e.g., the sensor module 204 in FIG. 2) disposed to be exposed outside through at least a portion of the display 201.

According to an embodiment, the camera module 230 may include at least one camera module, for example, at least one of the multiple camera modules illustrated in FIGS. 4 and 5. In an embodiment, the camera module 230 may be disposed on a portion of the support structure 212 at a position near the printed circuit boards 240a and 240b. In another embodiment, the camera module 230 may be at least partially enclosed by the rear case 250 (e.g., the upper rear case 250a). According to an embodiment, the camera module 230 may receive, inside the electronic device 101, at least some of the light entering through optical holes or cover windows 232 and 233 disposed on the rear surface (e.g., the second outer surface 210B in FIG. 3) of the electronic device 101. According to an embodiment, the camera module 230 may generally be aligned with any of the cover windows 232 and 233.

According to an embodiment, the printed circuit boards 240a and 240b may include circuit devices implemented in the form of integrated circuit chips (e.g., a processor), a communication module (e.g., communication module 190 in FIG. 1), a power management module (e.g., the power management module 188), memory (e.g., the memory 130 in FIG. 1), an interface (e.g., the interface 177 in FIG. 1), or various electrical/electronic components. The processor (e.g., the processor 120 in FIG. 1) may include one or more of a central processing unit (CPU), an application processor, a graphics processing unit (GPU), an image signal processor, a sensor hub processor, or a communication processor. The memory may include, for example, volatile memory or non-volatile memory. The interface may include, for example, a high-definition multimedia interface (HDMI), a universal serial bus (USB) interface, an SD card interface, and/or an audio interface. The interface may electrically or physically connect, for example, the electronic device 101 to an external electronic device, and may include a USB connector, an SD card/MMC connector, or an audio connector. According to an embodiment, the printed circuit boards 240a and 240b may be provided with electromagnetic shielding from the rear case 250.

According to an embodiment, the battery 245 is a device that supplies power to at least one component of the electronic device 101, and may include, for example, a non-rechargeable primary battery, a rechargeable secondary battery, or a fuel cell. At least a portion of the battery 245 may be disposed on substantially the same plane as, for example, the printed circuit boards 240a and 240b. The battery 245 may be integrally disposed inside the electronic device 101 or may be detachably disposed on the electronic device 101.

According to an embodiment, the rear case 250 may include an upper rear case 250a and a lower rear case 250b. In an embodiment, the upper rear case 250a may be disposed to enclose the printed circuit boards 240a and 240b (e.g., the first circuit board 240a) together with a portion of the support structure 212. For example, the upper rear case 250a may be disposed to face the support structure 212 with the first circuit board 240a interposed therebetween.

According to another embodiment, the lower rear case 250b may serve as a structure to place various electrical/electronic components, such as an interface (e.g., a USB connector, an SD card/MMC connector, or an audio connector). According to an embodiment, electrical/electronic components, such as an interface (e.g., a USB connector, an SD card/MMC connector, or an audio connector), may be disposed on an additional printed circuit board (not illustrated). In this case, the lower rear case 250b may be disposed to enclose the additional printed circuit board (not illustrated) together with another portion of the support structure 212. For example, the interface disposed on the additional printed circuit board (not illustrated) or the lower rear case 250b may be disposed to correspond to the sound hole 207 or the connector holes 208 and 209 illustrated in FIG. 2.

According to an embodiment, an antenna (not illustrated) may include a conductor pattern implemented on the surface of the rear case 250, for example, through a laser direct structuring (LDS) process. In an embodiment, the antenna may include a printed circuit pattern provided on the surface of a thin film, and the thin film-type antenna may be disposed between the rear surface plate 290 and the battery 245. The antenna may include, for example, a near-field communication (NFC) antenna, a wireless charging antenna, and/or a magnetic secure transmission (MST) antenna. The antenna may, for example, perform short-distance communication with an external device, or wirelessly transmit and receive power required for charging. In an embodiment, another antenna structure may be configured by a portion of, or a combination of, the support structure 212 and/or the side structure 211.

FIG. 4 is a front exploded perspective view of an electronic device according to an embodiment of the disclosure. FIG. 5 is a rear exploded perspective view of the electronic device according to an embodiment of the disclosure.

Referring to FIGS. 4 and 5, the electronic device 101 (e.g., the electronic device 101 in FIG. 1 and/or the electronic device 101 in FIG. 2 or 3) may include a display 201 (e.g., the display 201 in FIG. 2), a front surface plate 202 (e.g., the front surface plate 202 in FIG. 2), a support structure 212 (e.g., a bracket), a side surface bezel structure 222, a camera module 230 (e.g., the camera module 180 in FIG. 1), one or more printed circuit boards (or PCB assemblies) 240a and 240b, a battery 245 (e.g., the battery 189 in FIG. 1), a rear case 250, an antenna (not illustrated) (e.g., the antenna module 197 in FIG. 1), and/or a rear surface plate 290 (e.g., the rear surface plate 218 in FIG. 3). According to an embodiment, when the electronic device 101 includes multiple printed circuit boards 240a and 240b, the electronic device 101 may include at least one flexible printed circuit board 240c to electrically connect different printed circuit boards. For example, the printed circuit boards 240a and 240b may include a first circuit board 240a positioned above the battery 245 (e.g., in the +Y-axis direction) and a second circuit board 240b positioned below the battery 245 (e.g., in the -Y-axis direction), and the flexible printed circuit board 240c may electrically connect the first circuit board 240a and the second circuit board 240b.

According to an embodiment, the electronic device 101 may omit at least one component (e.g., the support structure 212, the rear case 250, or the flexible printed circuit board 240c) or may include additional components. At least one of the components of the electronic device 101 may be the same as or similar to at least one of the components of the electronic device 101 of FIG. 2 or FIG. 3, and a redundant description thereof is omitted below.

In an embodiment, the support structure 212 may be provided in at least a partially planar form. In another embodiment, the support structure 212 may be disposed inside the electronic device 101 and may be either connected to or integrated with the side surface structure 211. For example, the support structure 212 may be made of a conductive material and/or a non-conductive material (e.g., polymer). When the support structure 212 includes a conductive material such as metal, a portion of the side surface structure 211 or the support structure 212 may function as an antenna. The support structure 212 may have two surfaces facing away from each other. The display 201 may be disposed on one of the two surfaces of the support structure 212, while the printed circuit boards 240a and 240b may be disposed on the other surface.

According to an embodiment, the support member 212 and the side surface structure 211 may be combined to be referred to as a front case or a housing 210. According to an embodiment, the housing 210 may be generally understood as a structure to accommodate, protect, or place electrical/electronic components such as printed circuit boards 240a and 240b or a battery 245. In an embodiment, it may be understood that the housing 210 includes structures that a user may visually or tactfully recognize in the exterior of the electronic device 101, such as the side surface structure 211, the front surface plate 202, and/or the rear surface plate 290. In an embodiment, the "front surface or rear surface of the housing 210" may refer to the first surface 210A in FIG. 2 or the second surface 210B in FIG. 3. In an embodiment, the support member 212 may be disposed between the front surface plate 202 (e.g., the first surface 210A in FIG. 2) and the rear surface plate 290 (e.g., the second surface 210B in FIG. 3) and may serve as a structure on which electrical/electronic components, such as the printed circuit boards 240 and 240b or the camera module 230, are disposed. In the following detailed description, the camera module 230 of the electronic device 101 may generally be illustrated as including a configuration that receives light that enters through the second surface 210B of the electronic device 101. However, the electronic device 101 may further include a camera module (e.g., the camera module 205 in FIG. 2) and/or a sensor module (e.g., the sensor module 204 in FIG. 2) disposed to be exposed outside through at least a portion of the display 201.

According to an embodiment, the camera module 230 may include at least one camera module, for example, at least one of the multiple camera modules illustrated in FIGS. 4 and 5. In an embodiment, the camera module 230 may be disposed on a portion of the support structure 212 at a position near the printed circuit boards 240a and 240b. In another embodiment, the camera module 230 may be at least partially enclosed by the rear case 250 (e.g., the upper rear case 250a). According to an embodiment, the camera module 230 may receive, inside the electronic device 101, at least some of the light entering through optical holes or cover windows 232 and 233 disposed on the rear surface (e.g., the second surface 210B in FIG. 3) of the electronic device 101. According to an embodiment, the camera module 230 may generally be aligned with any of the cover windows 232 and 233.

According to an embodiment, the printed circuit boards 240a and 240b may include circuit devices implemented in the form of integrated circuit chips (e.g., a processor), a communication module (e.g., communication module 190 in FIG. 1), a power management module (e.g., the power management module 188), memory (e.g., the memory 130 in FIG. 1), an interface (e.g., the interface 177 in FIG. 1), or various electrical/electronic components. The processor (e.g., the processor 120 in FIG. 1) may include one or more of a central processing unit (CPU), an application processor, a graphics processing unit (GPU), an image signal processor, a sensor hub processor, or a communication processor. The memory may include, for example, volatile memory or non-volatile memory. The interface may include, for example, a high-definition multimedia interface (HDMI), a universal serial bus (USB) interface, an SD card interface, and/or an audio interface. The interface may electrically or physically connect, for example, the electronic device 101 to an external electronic device, and may include a USB connector, an SD card/MMC connector, or an audio connector. According to an embodiment, the printed circuit boards 240a and 240b may be provided with electromagnetic shielding from the rear case 250.

According to an embodiment, the battery 245 is a device that supplies power to at least one component of the electronic device 101, and may include, for example, a non-rechargeable primary battery, a rechargeable secondary battery, or a fuel cell. At least a portion of the battery 245 may be disposed on substantially the same plane as, for example, the printed circuit boards 240a and 240b. The battery 245 may be integrally disposed inside the electronic device 101 or may be detachably disposed on the electronic device 101.

According to an embodiment, the rear case 250 may include an upper rear case 250a and a lower rear case 250b. In an embodiment, the upper rear case 250a may be disposed to enclose the printed circuit boards 240a and 240b (e.g., the first circuit board 240a) together with a portion of the support structure 212. For example, the upper rear case 250a may be disposed to face the support structure 212 with the first circuit board 240a interposed therebetween.

According to another embodiment, the lower rear case 250b may serve as a structure to place various electrical/electronic components, such as an interface (e.g., a USB connector, an SD card/MMC connector, or an audio connector). According to an embodiment, electrical/electronic components, such as an interface (e.g., a USB connector, an SD card/MMC connector, or an audio connector), may be disposed on an additional printed circuit board (not illustrated). In this case, the lower rear case 250b may be disposed to enclose the additional printed circuit board (not illustrated) together with another portion of the support structure 212. For example, the interface disposed on the additional printed circuit board (not illustrated) or the lower rear case 250b may be disposed to correspond to the sound hole 207 or the connector holes 208 and 209 illustrated in FIG. 2.

According to an embodiment, an antenna (not illustrated) may include a conductor pattern implemented on the surface of the rear case 250, for example, through a laser direct structuring (LDS) process. In an embodiment, the antenna may include a printed circuit pattern provided on the surface of a thin film, and the thin film-type antenna may be disposed between the rear surface plate 290 and the battery 245. The antenna may include, for example, a near-field communication (NFC) antenna, a wireless charging antenna, and/or a magnetic secure transmission (MST) antenna. The antenna may, for example, perform short-distance communication with an external device, or wirelessly transmit and receive power required for charging. In an embodiment, another antenna structure may be configured by a portion of, or a combination of, the support structure 212 and/or the side structure 211.

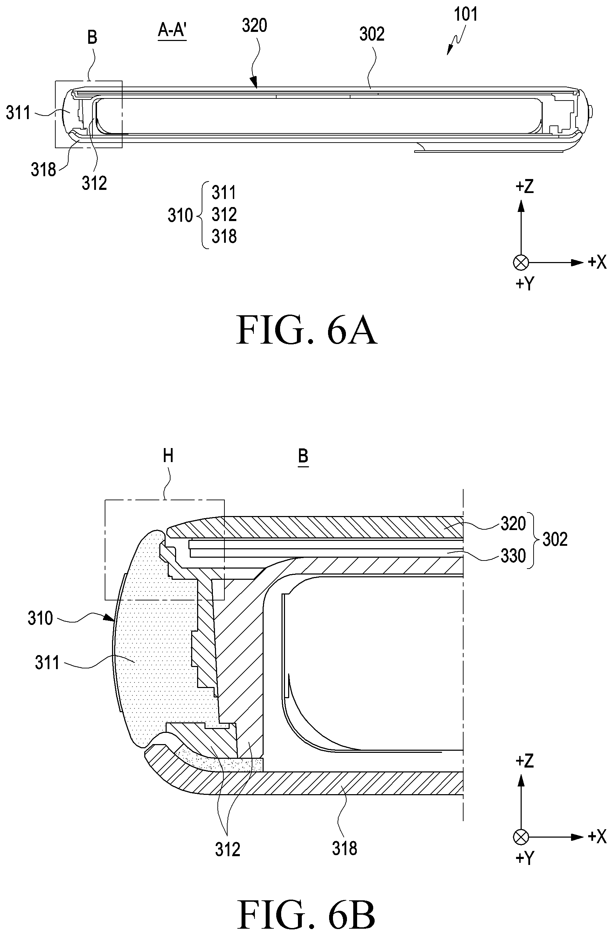

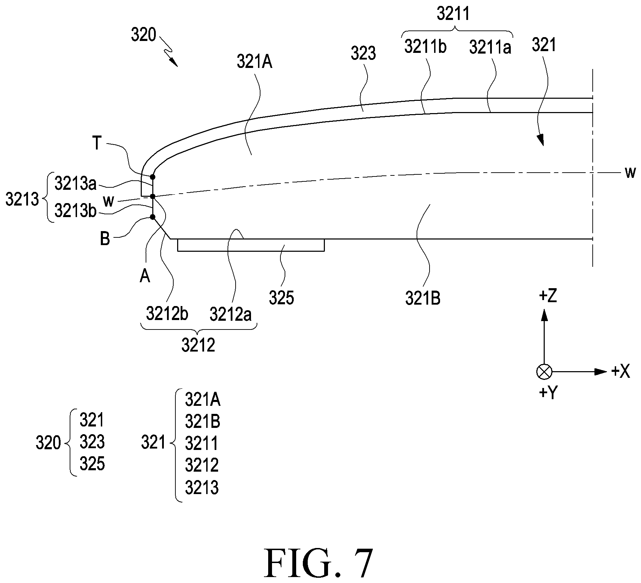

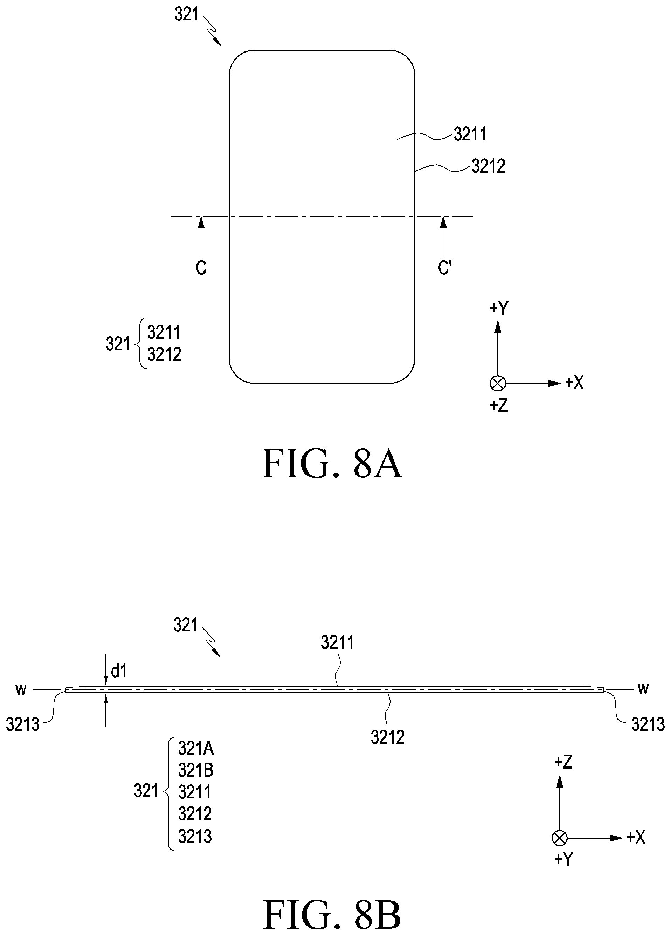

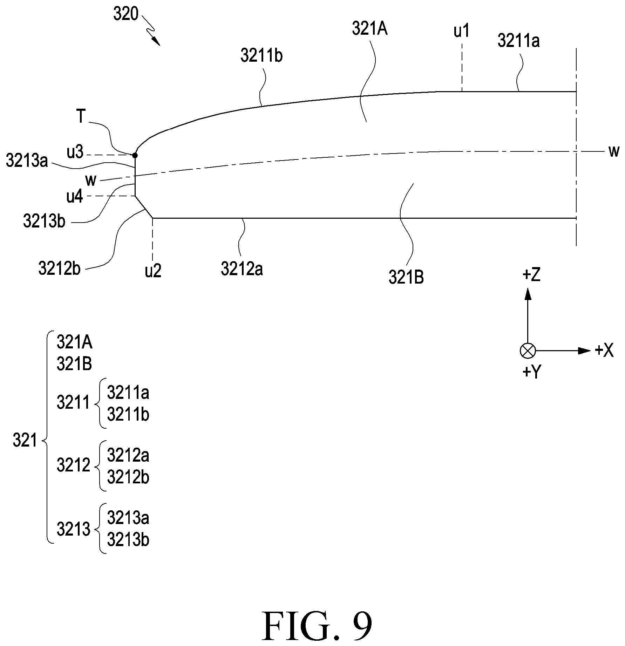

FIG. 6A is a cross-sectional view taken along line A-A' of FIG. 2, according to an embodiment of the disclosure. FIG. 6B is an enlarged view of part "B" of FIG. 6A, according to an embodiment of the disclosure. FIG. 7 is a partial cross-sectional side view of a window assembly according to an embodiment of the disclosure. FIG. 8A is a plan view of a cover window according to an embodiment of the disclosure. FIG. 8B is a cross-sectional view taken along line C-C' of FIG. 8A, according to an embodiment of the disclosure. FIG. 9 is a partial cross-sectional side view of a cover window according to an embodiment of the disclosure.

All or part of the configuration of the electronic device 101 in FIG. 6A may be the same as or similar to the configuration of the electronic device 101 illustrated in FIGS. 1 to 5. The housing 310 in FIGS. 6A and 6B may be referred to as the housing 210 illustrated in FIGS. 2 to 5. The housing 310 in FIGS. 6A and 6B may be referred to as the housing 210 illustrated in FIGS. 2 to 5.

Referring to FIGS. 6A and 6B, in an embodiment, the electronic device 101 may include a housing 310 and a display assembly 302. According to an embodiment, the housing 310 may include a side surface structure 311 (e.g., the side surface structure 211 in FIGS. 2 to 5) that is disposed around the display assembly 302 and defines the side surface (e.g., the side surface 210C in FIG. 2) of the electronic device 101, and a rear surface plate 318 (e.g., the rear surface plate 218 in FIG. 3, and the rear surface plate 290 in FIGS. 4 and 9) that defines the rear surface (e.g., the second surface 210B in FIG. 3) of the electronic device 101.

Referring to FIGS. 6B, 7, 8A, 8B, and 9, according to an embodiment, the display assembly 302 may include a display panel 330 (e.g., the display 201 in FIGS. 2, 4, and 5), and a window assembly 320 (e.g., the front surface plate 202 in FIGS. 2, 4, and 5) that is disposed on one surface (e.g., the front surface or +Z direction surface) of the display panel 330 and defines the front surface (e.g., the first surface 210A in FIG. 2) of the electronic device 101. For example, the display panel 330 and the window assembly 320 may be coupled or bonded to each other with an adhesive member provided therebetween. According to an embodiment, the display assembly 302 may be implemented as a flexible display that is foldable or rollable, and may be implemented with a material that is foldable or rollable (e.g., flexible glass) while being coupled to the display panel 330.

According to an embodiment, an image (e.g., a picture or a video) output or provided from the display panel 330 may be transmitted outside the electronic device 101 through the display assembly 302. According to an embodiment, the display panel 330 may include an active area configured to output an image and an inactive area disposed around the active area and configured not to output an image.

According to an embodiment, the window assembly 320 may be disposed to overlap or face both the active and inactive areas of the display panel 330 in the thickness direction of the electronic device 101 (e.g., the Z-axis direction). Referring to FIG. 7, in an embodiment, the window assembly 320 may include a cover window 321 and a coating layer 323 disposed or laminated on a portion of the cover window 321. In an embodiment, the window assembly 320 may further include a black layer (or black marking layer) 325 disposed or laminated on a portion of the cover window 321 to be positioned between the cover window 321 and the display panel 330.

In an embodiment, the cover window 321 may be fabricated to be substantially transparent and may include, for example, glass, ceramic, and/or synthetic resin. Referring to FIGS. 7, 8A, 8B, and 9, in an embodiment, the cover window 321 may include a first surface 3211 exposed outside the electronic device 101, a second surface 3212 facing away from the first surface 3211 (or on the opposite side of the first surface 3211), and an edge surface 3213 connecting the first surface 3211 and the second surface 3212.

Referring to FIGS. 7, 8A, 8B, and 9, according to an embodiment, the first surface 3211 of the cover window 321 may include a (1-1)^{th} surface 3211a disposed in the central portion of the first surface 3211 and a (1-2)^{th} surface 3211b disposed at the edge of the first surface 3211 and extending between the (1-1)^{th} surface 3211a and the first edge area 3213a of the edge surface 3213. For example, the (1-1)^{th} surface 3211a and the (1-2)^{th} surface 3211b may be distinguished by the dotted line ul in FIG. 9. According to an embodiment, the (1-1)^{th} surface 3211a of the first surface 3211 of the cover window 321 may include a flat surface, and the (1-2)^{th} surface 3211b may include a curved surface.

According to an embodiment, the second surface 3212 of the cover window 321 may include a (2-1)^{th} surface 3212a disposed in the central portion of the second surface 3212 and an inclined (2-2)^{th} surface 3212b disposed at the edge of the second surface 3212 and extending between the (2-1)^{th} surface 3212a and the second edge area 3213b of the edge surface 3213. For example, the (2-1)^{th} surface 3212a and the (2-2)^{th} surface 3212b may be distinguished by the dotted line u2 in FIG. 9. According to an embodiment, the (2-1)^{th} surface 3212a of the second surface 3212 of the cover window 321 may include a flat surface, and the (2-2)^{th} surface 3212b may be inclined with respect to the (2-1)^{th} surface 3212a.

According to an embodiment, the edge surface 3213 of the cover window 321 of the window assembly 320 may include a first edge area 3213a extending from the first surface 3211 and a second edge area 3213b extending from the second surface 3212. For example, the (2-1)^{th} surface 3212a and the (2-2)^{th} surface 3212b may be distinguished by the dotted line u2 in FIG. 9.

Referring to FIG. 8A, according to an embodiment, the cover window 321 may have a rectangular plate shape, and the corners may be chamfered, tapered, or rounded. However, the shape of the cover window 321 in the disclosure is not limited and may be formed in various polygonal plate shapes, such as circular or non-rectangular shapes, depending on the shape of the display panel 330.

Referring to FIGS. 7, 8B, and 9, according to an embodiment, the cover window 321 may include a neutral plane (indicated by the dashed line W-W) disposed between the first surface 3211 and the second surface 3212. In the disclosure, the neutral plane may be understood as an imaginary plane illustrating the interface where a compressive stress-resistant portion and a tensile stress-resistant portion of the cover window 321 against external force are divided. In the disclosure, the neutral plane is an imaginary plane that intersects the thickness direction of the electronic device 101 (e.g., the Z-axis direction) and may be indicated by the dashed line W-W in the cross-sectional side view (e.g., FIGS. 7, 8B, and 9). According to an embodiment, the cover window 321 may include a first portion 321A disposed between the neutral plane and the first surface 3211 and configured to resist compressive stress, and a second portion 321B disposed between the neutral plane and the second surface 3212 and configured to resist tensile stress.

In an embodiment, the coating layer 323 may be disposed to cover a portion of the edge surface 3213 (e.g., a portion of the first edge area 3213a) that is not positioned on the second portion 321B of the cover window 321, which is a tensile-resistant area. Accordingly, preferably, the second edge area 3213a of the edge surface 3213 may be disposed to be higher than the neutral plane indicated by the dashed line W-W in the cross-sectional side views (e.g., FIGS. 7, 8B, and 9), so that the coating layer 323 is disposed on the second portion 321B of the cover window 321, which is a tensile-resistant area, thereby preventing deterioration of the durability of the cover window 321.

According to an embodiment, the first edge area 3213a and the second edge area 3213b of the edge surface 3213 may be partially disposed on the first portion 321A of the cover window 321. On the second portion 321B of the cover window 321, the remaining portion of the second edge area 3213b of the edge surface 3213 may be disposed. According to an embodiment, during the manufacturing process, the cover window 321 may be subjected to strengthening treatment to have sufficient bending strength and impact strength against impacts due to dropping or external forces applied during use. For example, the bending strength and impact strength of the cover window 321 may be directly related to drop performance. For example, when the coating layer 323 is formed on the second surface 3212 of the cover window 321, which is a tensile-resistant area, the possibility of damage may increase when external force is applied to the second surface 3212. According to the embodiments of the disclosure, the coating layer 323 may be formed only on target areas excluding the second surface 3212 of the cover window 321, which is a tensile-resistant area, thereby improving the drop performance of the cover window 321.

According to an embodiment, the coating layer 323 of the window assembly 302 may be configured to physically and/or chemically protect the cover window 321. For example, the coating layer 323 may be formed to provide easy cleaning and scratch-resistant properties and may include a hard coating layer, an anti-reflective coating layer, a low-reflective coating layer, and/or an anti-glare coating layer.

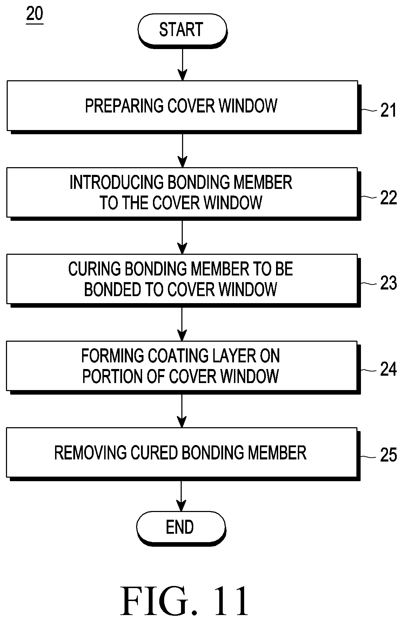

According to an embodiment, the coating layer 323 of the window assembly 302 may be disposed or laminated on the first surface 3211 of the cover window 321 and at least a portion of the first edge area 3213a of the edge surface 3213. For example, the coating layer 323 may be formed to cover the entirety of the first surface 3211 of the cover window 321. According to an embodiment, the coating layer 323 of the window assembly 302 may not be disposed on the second edge area 3213b of the edge surface 3213 of the cover window 321. According to an embodiment, in the state in which the cover window 321 is assembled into the electronic device 101, the boundary between the area where the coating layer 323 is not formed and the area where the coating layer 323 is formed on the cover window 321 may not be visible from the exterior of the electronic device 101. According to an embodiment to be described below referring to FIGS. 11, 12A, 12B, 13A, 13B, and 14A, 14B, 14C, when a coating material is applied to form the coating layer 323 on the cover window 321 seated on the fixing member 10, the coating layer 323 may be formed only on a target area (e.g., the first surface 3211 and at least a portion of the first edge area 3213a) on the cover window 321, and the coating material may be prevented from flowing beyond the target area, particularly into the second edge area 3213b and/or the second surface 3212 of the cover window 321.

According to an embodiment, the black layer 325 of the window assembly 302 may be disposed between the display panel 330 and the second surface 3212 of the display panel 330. The black layer 325 may be disposed to face a portion of one surface (e.g., the front surface or +Z direction surface) of the display panel 330. According to an embodiment, the black layer 325 may be disposed on the second surface 3212 of the cover window 321 to face the inactive area of the display panel 330, which is configured to not output an image. According to an embodiment, the active area of the display panel 330 may be disposed in the central portion of the display panel 330, and the inactive area may be disposed around the active area at the edge area of the display panel 330. According to an embodiment, the black layer 325 may conceal components (e.g., the inactive area of the display panel 330) disposed inside it so that the components are not visible outside the electronic device 101.

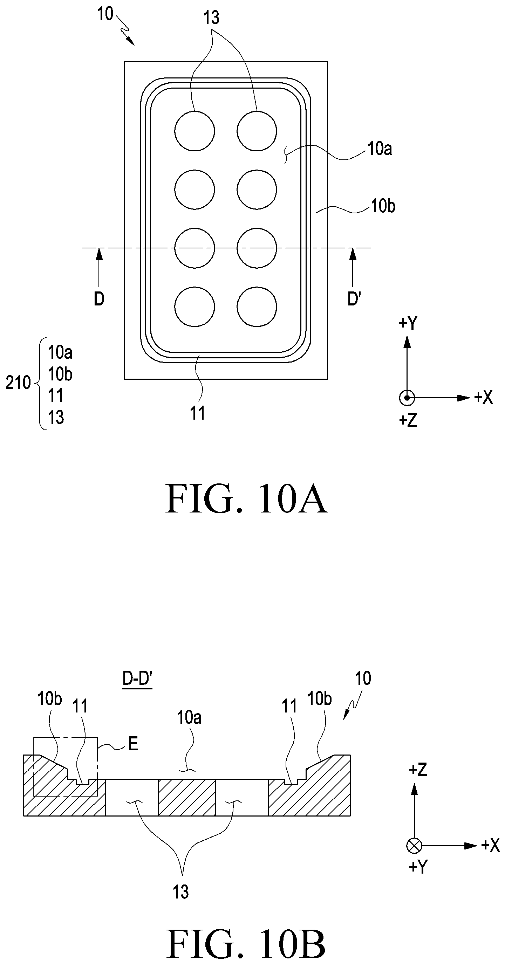

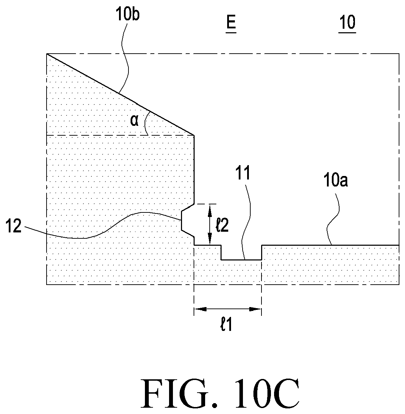

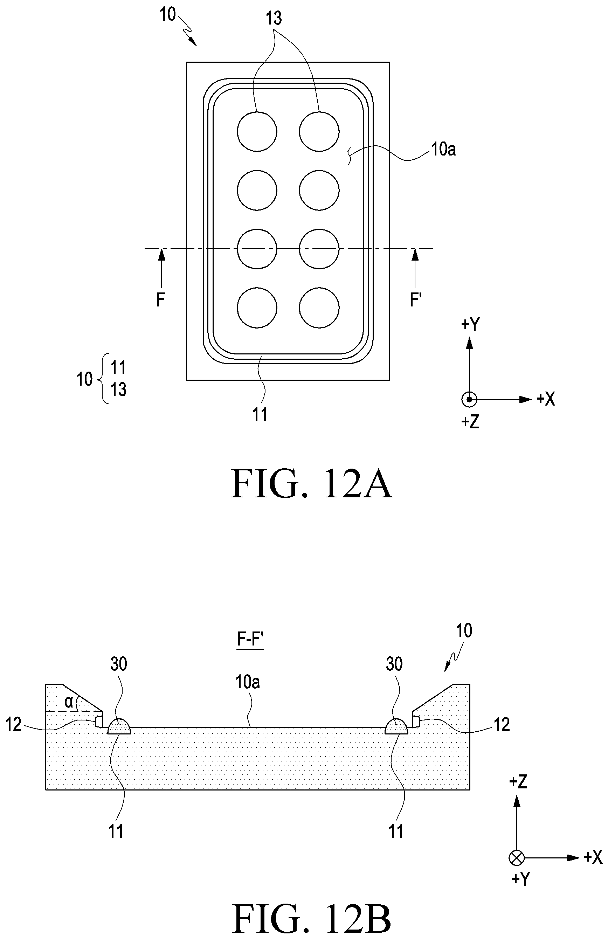

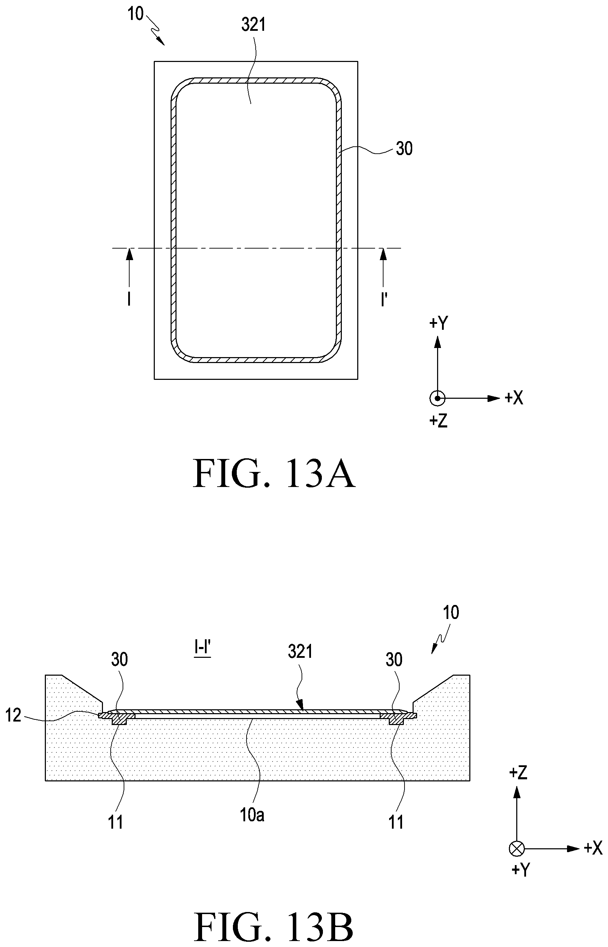

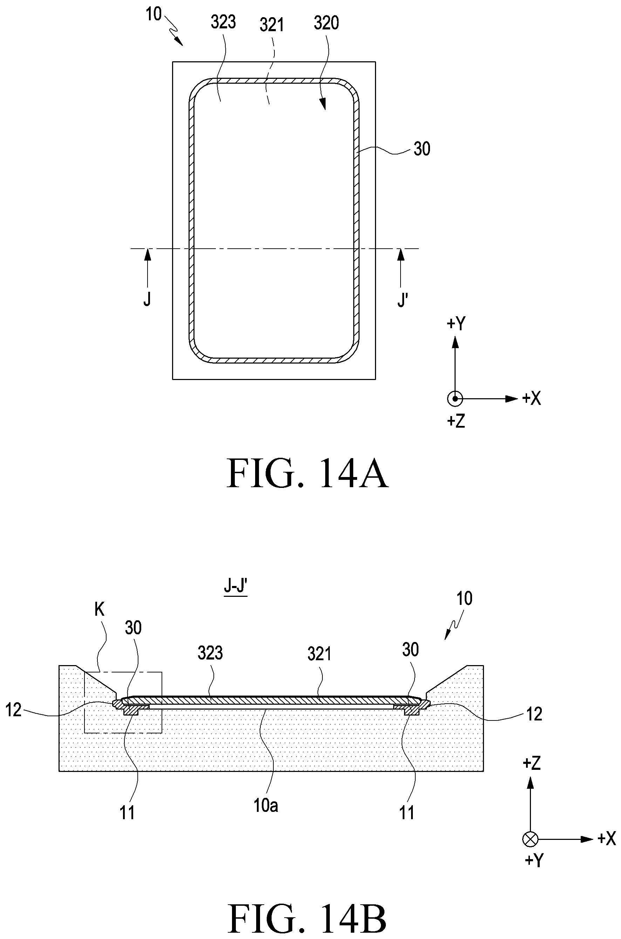

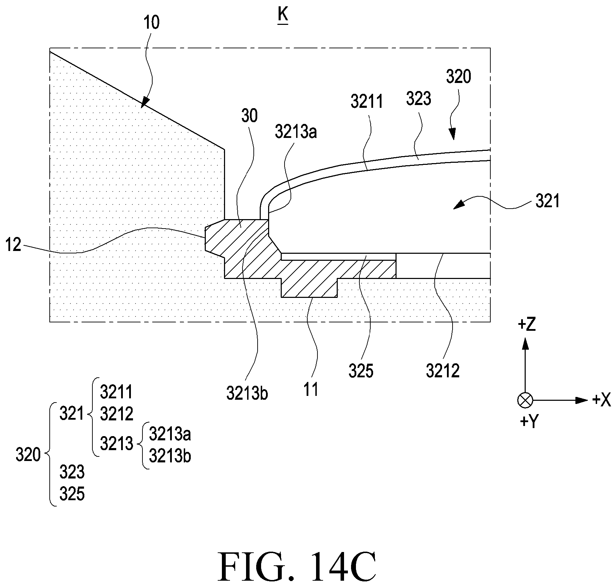

FIG. 10A is a plan view of a fixing member according to an embodiment of the disclosure. FIG. 10B is a cross-sectional side view of the fixing member taken along line D-D' of FIG. 10A, according to an embodiment of the disclosure. FIG. 10C is an enlarged view of part E in FIG. 10B, according to an embodiment of the disclosure. FIG. 11 is a flowchart illustrating a method of manufacturing a window assembly according to an embodiment of the disclosure. FIG. 12A is a plan view illustrating a fixing member and an adhesive member according to an embodiment of the disclosure. FIG. 12B is a cross-sectional view taken along line F-F' of FIG. 12A, illustrating the fixing member and the adhesive member according to an embodiment of the disclosure. FIG. 13A is a plan view illustrating a fixing member, an adhesive member, and a cover window according to an embodiment of the disclosure. FIG. 13B is a cross-sectional view taken along line I-I' of FIG. 13A, illustrating the fixing member, the adhesive member, and the cover window according to an embodiment of the disclosure. FIG. 14A is a plan view of a fixing member, an adhesive member, and a window assembly according to an embodiment of the disclosure. FIG. 14B is a cross-sectional view taken along line J-J' of FIG. 13A, illustrating the fixing member, the adhesive member, and the window assembly according to an embodiment of the disclosure. FIG. 14C is an enlarged view of part K in FIG. 14B, according to an embodiment of the disclosure.

Referring to FIGS. 10A to 10C, in an embodiment, a fixing member 10 (or jig) for manufacturing or fabricating the window assembly 302 (or for the cover window 321) may be provided. In an embodiment, operations 21, 22, 23, and 24 of a method of manufacturing the window assembly 302 in operation 20 as described below with reference to FIG. 11, may be performed while the cover window 321 is seated or fixed on the fixing member 10 (or jig) illustrated in FIGS. 10A to 10C, according to an embodiment.

According to an embodiment, the fixing member 10 may be formed to allow the cover window 321 to be seated and/or fixed. With the fixing member 10, according to an embodiment, when a coating material is applied to form the coating layer 323 on the cover window 321 seated on the fixing member 10, the coating layer 323 may be formed only on a target area (e.g., the first surface 3211 and at least a portion of the first edge area 3213a) on the cover window 321, and the coating material may be prevented from flowing beyond the target area, particularly into the second edge area 3213b and/or the second surface 3212 of the cover window 321.

Referring to FIGS. 10A to 10C, according to an embodiment, the fixing member 10 may include a seating portion 10a, an inclined portion 10b, a first groove 11, a second groove 12, and a through hole 133. According to an embodiment, some components of the fixing member 10 (e.g., the first groove 11, the second groove 12, and the through hole 13) may be omitted.

According to an embodiment, the seating portion 10a of the fixing member 10 may be formed to allow the cover window 321 to be seated thereon. For example, the first groove 11 may have a closed-loop shape formed along the edge of the fixing member 10. The seating portion 10a may be shaped to correspond to the shape of the cover window 321 and may be, for example, a recess formed in the central portion of the fixing member 10. Referring to FIG. 10C, for example, the inclined portion 10b may be formed at an angle α of about 20 degrees to about 45 degrees, preferably about 30 degrees, relative to the bottom surface of the seating portion 10a. For example, the inclined portion 10b may help the coating material to be evenly distributed over the entire surface of the cover window 321.

According to an embodiment, the first groove 11 of the fixing member 10 may be formed along at least a portion of the edge of the bottom surface (e.g., the +Z direction surface) of the seating portion 10a of the fixing member 10. For example, the first groove 11 may have a closed-loop shape. According to an embodiment, the first groove 11 may be a recess formed in the seating portion 10a and may extend or depress in the rearward direction (e.g., the -Z direction). Referring to FIG. 10C, a first linear distance 11 from the edge of the seating portion 10a to the area where the first groove 11 is formed may be configured such that the first groove 11 faces the edge area of the cover window 321 when the cover window 321 is disposed on the seating portion 10a.

According to an embodiment, the second groove 12 in the fixing member 10 may be spaced apart from the first groove 11. According to an embodiment, the second groove 12 may be formed along at least a portion of the edge of the bottom surface (e.g., the +Z direction surface) of the seating portion 10a of the fixing member 10. For example, the second groove 12 may have a closed-loop shape. According to one embodiment, the second groove 12 may be a recess formed in the seating portion 10a and may be formed to extend or depress in a different direction from the first groove 11 (e.g., laterally or in a direction orthogonal to the Z-axis). Referring to FIG. 10C, the second linear distance l2 from the edge of the seating portion 10a to the area where the second groove 12 is formed may be configured such that, when disposed on the seating portion 10a, the cover window 321 is not higher than the interface line between the first edge area 3213a and the second edge area 3213b of the cover window 321, thereby allowing the height (e.g., the Z-axis direction height) at which the adhesive member 30 (or bonding member or adhesive) is disposed (e.g., ink bonding) on the edge surface 3213 of the cover window 321 to be controlled. In the disclosure, the term "adhesive member 30" may refer to a material that is in a liquid, semisolid, or solid state and contains an adhesive material.

According to an embodiment, the through hole 13 in the fixing member 10 may be formed around the seating portion 10a. According to an embodiment, the through hole 13 may be formed through the seating portion 10a in the front and rear direction (e.g., the Z-axis direction). For example, multiple through holes 13 may be provided to be spaced apart from each other. The through holes 13 may help dissipate heat from the seating portion 10a to the outside of the fixing member 10.

According to an embodiment, the first groove 11 or the second groove 12 in the fixing member 10 may prevent the adhesive member 30, which is disposed between the cover window 321 and the fixing member 10, from overflowing toward the front surface of the cover window 321, as described below with reference to FIGS. 12A, 12B, 13A, and 13B. With the first groove 11 or the second groove 12 in the fixing member 10, the adhesive member 30 does not overflow into the target area where the coating layer 323 is to be formed on the cover window 321, thereby making the coating material applicable to the target area of the cover window 321.

Hereinafter, a method of manufacturing the window assembly 302 according to the embodiment described above with reference to FIGS. 6A, 6B, 7, 8A, 8B, and 9 is described with reference to FIGS. 10A, 10B, 10C, 11, 12A, 12B, 13A, 13B, and 14A, 14B, and 14C.

Referring to FIGS. 10A, 10B, 10C, and 11, in an embodiment of the disclosure, operation 20 illustrates a method of manufacturing the window assembly 302 in operation 20may include operation 21 of preparing (or fabricating, forming) a cover window 321, operation 22 includes introducing an adhesive member 30 (or bonding member or adhesive) (e.g., ink bonding) to the cover window 321, operation 23 includes curing the adhesive member 30 to couple (or bond) it to the cover window 321, operation 24 includes forming the coating layer 323 on a portion (or target area) of the cover window 321, and operation 25 includes removing the cured adhesive member 30.

According to an embodiment, the preparing of the cover window 321 in operation 21 may include forming a basic shape of the cover window 321 (e.g., cutting the material (e.g., computer numerical control (CNC) machining)), polishing the surface of the cover window 321, and strengthening the cover window 321. According to an embodiment of the disclosure, operation 21 may further include performing pad printing on the strengthened cover window 321.

For example, in the preparing of the cover window 321 in operation 21, according the forming of the basic shape of the cover window 321 (e.g., cutting the material (e.g., CNC machining)), a (1-2)^{th} surface 3211b, which is chamfered (or inclined) or rounded, may be formed on the first surface 3211 of the cover window 321. For example, a (2-2)^{th} surface 3212b, which is chamfered (or inclined) or rounded, may be formed on the second surface 3212 of the cover window 321. For example, in the preparing of the cover window 321 in operation 21, the polishing of the surface of the cut material may include edge-polishing (E-PLS) to polish the edge of the cut material, and polishing both the first surface 3211 and the second surface 3212 of the cover window 321 after the edge polishing to make the cover window 321 highly glossy and remove flaws from the surface. The edge-polishing (E-PLS) may remove irregularities or flaws, such as scratches, depressions, tool marks, or microcracks on the edge surface 3213, and the (1-2)^{th} surface 3211b and the (2-2)^{th} surface 3212b, which are chamfered (or inclined) or rounded, thereby making the surfaces smooth. For example, in the preparing of the cover window 321 in operation 21, the strengthening of the cover window 321 may strengthen the resistance to external impacts, and the cover window 321 may be subjected to strengthening treatment to have sufficient bending strength and impact strength against impacts due to dropping or external force applied during use. For example, in the preparing of the cover window 321 in operation 21, the pad-printing may include disposing a printed layer in the area facing (or corresponding to) the active area of the display panel 330 on the second surface of the cover window 321 to define the active area, and disposing or forming a black layer 325 in the area facing (or corresponding to) the inactive area of the display panel 330 on the second surface of the cover window 321.

In FIGS. 12A, 12B, 13A, 13B, and 14A, 14B, 14C, illustration of the black layer 325 coupled to the cover window 321 is omitted, but in FIGS. 12A, 12B, 13A, 13B, 14A, 14B, and 14C and the following description, the cover window 321 may be in the state in which the black layer 325 is coupled thereto.

FIGS. 12A and 12B may illustrate introducing an adhesive member (e.g., the adhesive member 30 in FIGS. 12A and 12B) to the cover window 321 in operation 22 in the method of manufacturing the window assembly 302 in operation 20 according to an embodiment. According to an embodiment, the operation 22 may refer to disposing the cover window 321 on the fixing member 10 with the adhesive member 30 interposed therebetween so that the adhesive member 30 is introduced to the cover window 321. According to an embodiment, the adhesive member 30 may be applied to at least a portion of the first groove 11 and the seating portion 10a of the fixing member 10. According to an embodiment, the first groove 11 in the fixing member 10 may guide the position of the adhesive member 30 on the fixing member 10 and may increase the thickness of at least a portion of the adhesive member 30 to enhance the bonding or coupling strength between the cover window 321 and the fixing member 10.

According to an embodiment, preferably, the first groove 11 in the fixing member 10 may be positioned within the area corresponding to the black layer 325 of the cover window 321 when the cover window 321 is disposed on the fixing member 10. As the position of the first groove 11 of the fixing member 10, the adhesive member 30 may not be introduced to the area of the cover window 321 corresponding to the active area of the display panel 330, the effort to remove the adhesive member 30 disposed in the area of the cover window 321 corresponding to the active area of the display panel 330 may be reduced during 24.

FIGS. 13A and 13B may illustrate the curing of the adhesive member 30 to couple (or bond) the cover window 321 in operation 23 in the method of manufacturing the window assembly 302 in operation 20 according to an embodiment. For example, operation 23 may be performed by pressing the cover window 321 together with the adhesive member 30 onto the fixing member 10 to bond it to the fixing member 10 and curing the adhesive member 30. For example, the adhesive member 30 may be cured by applying ultraviolet light, microwaves, infrared light, thermal heating, or a combination thereof. For example, the degree to which the adhesive member 30 is cured may be configured such that the adhesive member 30 has a bonding strength that allows the cover window 321 to be detachably bonded to the fixing member 10.

FIGS. 14A, 14B, and 14C may illustrate the forming of the coating layer 323 on a portion (or target area) of the cover window 321 in operation 24 in the method of manufacturing the window assembly 302 in operation 20 according to an embodiment. According to an embodiment, since the adhesive member 30 covers the second edge area 3213b of the edge surface 3213 of the cover window 321, the coating layer 323 may be formed on the first surface 3211 of the cover window 321 and at least a portion of the first edge area 3213a adjacent to the first surface 3211. According to an embodiment, preferably, since the adhesive member 30 covers the second edge area 3213b of the edge surface 3213 of the cover window 321 and a portion of the first edge area 3213a adjacent to the second edge area 3213b, the coating layer 323 may be formed on the first surface 3211 of the cover window 321 and the remaining portion of the first edge area 3213a adjacent to the first surface 3211. In other words, the coating layer 323 may include a portion that covers the first surface 3211 of the cover window 321 and a portion that extends from that portion to cover a portion of the first edge area 3213a adjacent to the first surface 3211.

According to an embodiment, in the state in which the cover window 321 is assembled into the electronic device 101, the boundary between the area where the coating layer 323 is not formed and the area where the coating layer 323 is formed on the cover window 321 may not be visible from the exterior of the electronic device 101. For example, the coating layer 323 may be formed to provide easy cleaning and scratch-resistant properties and may include a hard coating layer, an anti-reflective coating layer, a low-reflective coating layer, and/or an anti-glare coating layer. For example, the coating layer 323 may be formed on the surface of the cover window 321 through various vacuum deposition methods, such as sputtering, physical vapor deposition (PVD), and chemical vapor deposition (CVD). Referring to FIG. 14C, according to an embodiment, the position of the second groove 12 in the fixing member 10 may be configured to control the height to which the adhesive member 30 is applied. For example, the second groove 12 in the fixing member 10 may face the second edge area 3213b and may also face a portion of the first edge area 3213a adjacent to the second edge area 3213b.

In the removing of the cured adhesive member 30 in operation 25 in the method for manufacturing the window assembly 302 in operation 20, the adhesive member 30 may be formed to be water-soluble, in which case the adhesive member 30 may be removed by immersing the cover window 321 in water in 25. For example, in the 25, some of the coating layer 323 formed on the adhesive member 30 may also be removed or peeled off. After 25, the coating layer 323 may remain on a target area of the cover window 321 that does not overlap the area where the adhesive member 30 was applied. The black layer 325 may remain on the cover window 321 without being affected by 25.

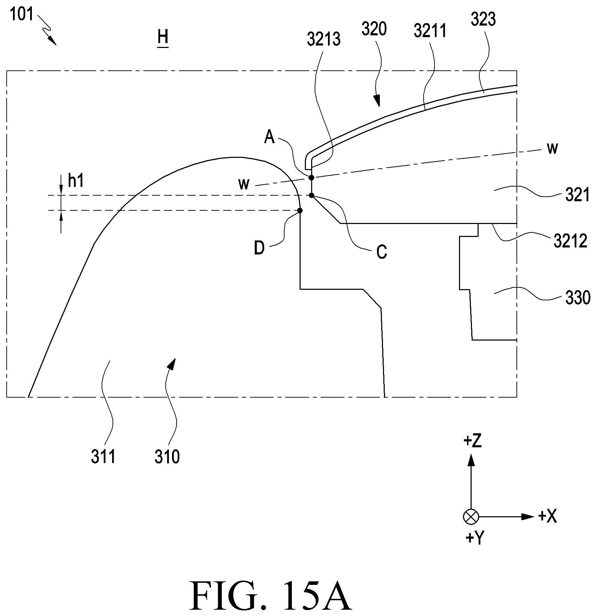

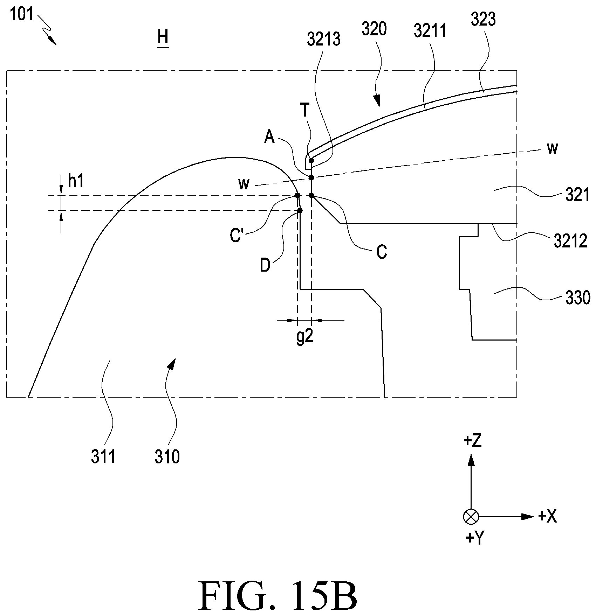

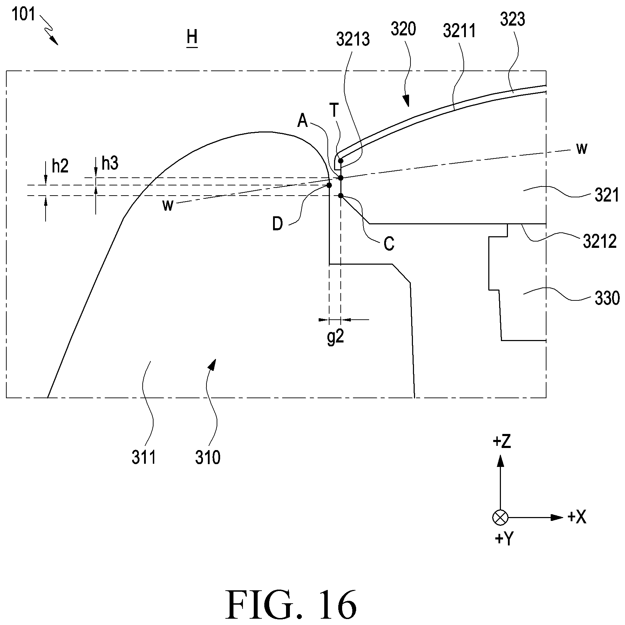

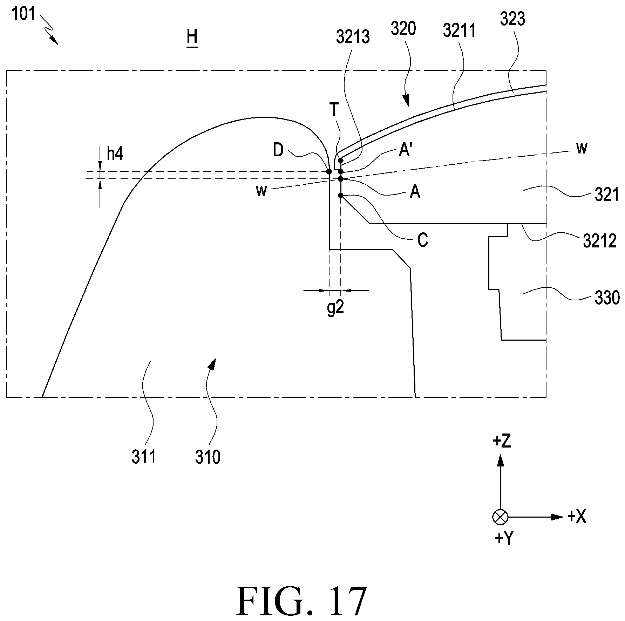

FIG. 15A is an enlarged view of part H of FIG. 6B, illustrating a housing, a window assembly, and a display panel according to an embodiment of the disclosure. FIG. 15B is an enlarged view of a portion of FIG. 15A according to an embodiment of the disclosure. FIG. 16 is an enlarged view of part H of FIG. 6B, illustrating the housing and the window assembly according to an embodiment of the disclosure. FIG. 17 is an enlarged view of part H of FIG. 6B, illustrating the housing and the window assembly according to an embodiment of the disclosure.

All or part of the configuration of the electronic device 101 in FIGS. 15A to 17 may be the same as or similar to the configuration of the electronic device 101 illustrated in FIGS. 1 to 5 and 6A. The housing 310 and the window assembly 302 according to the embodiments of FIGS. 15A, 15B, 16, and 17 may be referenced as the housing 310 and the window assembly 302 according to the embodiments of FIGS. 6A, 6B, 7, 8A, 8B, 9, 10A to 10C, 11, 12A, 12B, 13A, 13B, and 14A, 14B, and 14C.

Referring to FIGS. 15A, 15B, 16, and 17, "point D" of the housing 310 may refer to a point of the side wall of the housing 310 that protrudes closest to the edge surface 3213 of the cover window 321. "Point A" of the cover window 321 may refer to a point of the edge surface 3213 that is positioned at the neutral plane. "Point T" and "point C" of the cover window 321 may refer to upper and lower end points of the edge surface 3213 of the cover window 321. For example, the aforementioned "point D", "point A", "point T", and "point C" may be positioned on the same plane (e.g., the X-Z plane).

Referring to FIGS. 15B, 16, and 17, in an embodiment, the cover window 321 may be disposed to have a gap "g2" from the side wall of the housing 310. Here, the gap "g2" may be the minimum distance C-C' between the cover window 321 and the housing 310 (a horizontal distance or X-axis direction distance).

Referring to FIGS. 15A and 15B, in an embodiment, point A may be positioned higher than point D. Referring to FIG. 16, in an embodiment, point A may be positioned higher than point D. As in the embodiment of FIGS. 15A and 15B, when point D is lower than the neutral plane (indicated by the dashed line w-w in the drawings), the second edge area 3213b of the cover window 321 is preferably disposed on a portion of the edge surface 3213 that is higher than the neutral plane but lower than the first surface 3211.

Referring to FIGS. 15A and 15B, the height between point C and point D (the Z-axis direction height) may be indicated as h1. Referring to FIG. 16, the height between point C and point D (the Z-axis direction height) may be indicated as h2, and h1 may be greater than h2. Referring to FIG. 16, the height between point A and point D (Z-axis direction height) may be indicated as h3.

Referring to FIG. 17, in an embodiment, point A may be positioned lower than point D. Referring to FIG. 17, the height between point A and point D (the Z-axis direction height) may be indicated as h4. The height h4 may be the same as the height between point A and point A' (the Z-axis direction height) (A-A'), and the heights of point A' and point D (the Z-axis direction heights) may be the same. The gap "g2" may be the same as the minimum distance between point A and point D (A'-D). Referring to FIG. 17, the coating layer 323 may be applied while avoiding point A'. For example, the coating layer 323 may be disposed on the first surface 3211 of the cover window 321 and on an area of the edge surface 3213 that is adjacent to the first surface 3211 but lower than the first surface 3211 and higher than point A'.

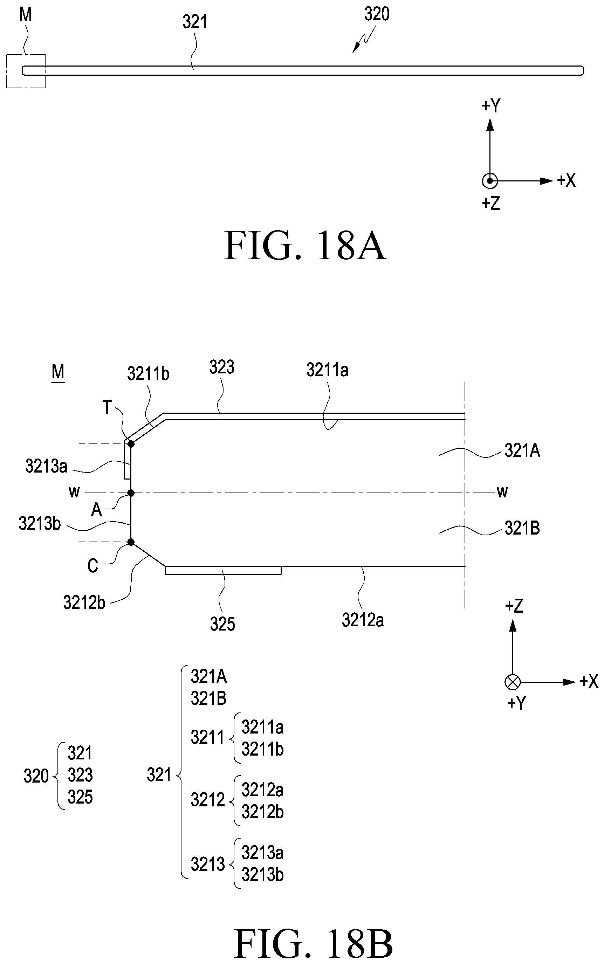

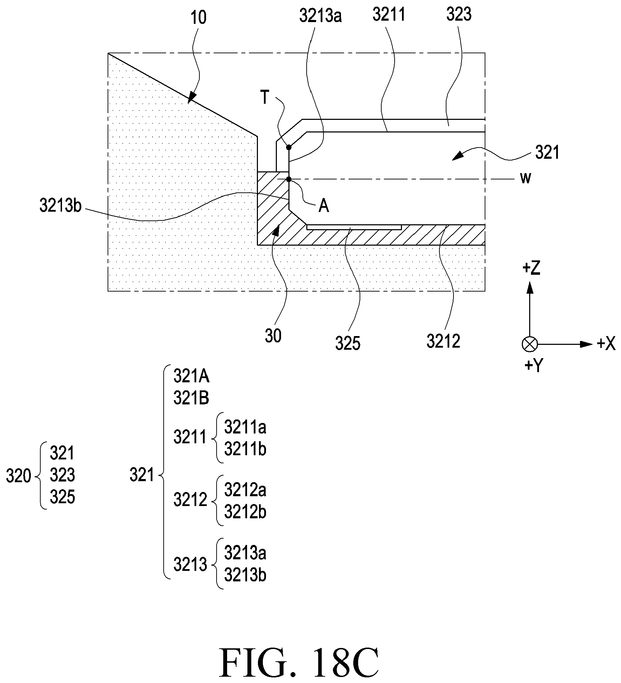

FIG. 18A is a side view of a window assembly according to an embodiment of the disclosure. FIG. 18B is an enlarged view of part M of FIG. 18A, illustrating the window assembly according to an embodiment of the disclosure. FIG. 18C is a cross-sectional side view illustrating a fixing member, an adhesive member, and a window assembly according to an embodiment of the disclosure.

All or part of the configuration of the cover window 321 in FIGS. 18A to 18C may be the same as or similar to the configuration of the cover window 321 according to the embodiments of FIGS. 6A, 6B, 7, 8A, 8B, 9, 10A to 10C, 11, 12A, 12B, 13A, 13B, 14A, 14B, 14C, 15A, 15B, 16, and 17. All or part of the configuration of the fixing member 10 in FIG. 18C may be the same as or similar to the configuration of the fixing member 10 according to the embodiments of FIGS. 11, 12A, 12B, 13A, 13B, and 14A, 14B, and 14C. The coating layer 323 and the black layer 325 in FIGS. 18A to 18C may be referenced as the coating layer 323 and the black layer 325 according to the embodiments of FIGS. 6A, 6B, 7, 8A, 8B, 9, 10A to 10C, 11, 12A, 12B, 13A, 13B, 14A, 14B, 14C, 15A, 15B, 16, and 17.

The embodiment of FIGS. 18A to 18C may differ in the shape for the (1-1)^{th} surface 3211a of the first surface 3211 of the window 321 from the embodiments described with reference to FIGS. 6A, 6B, 7, 8A, 8B, 9, 10A to 10C, 11, 12A, 12B, 13A, 13B, 14A, 14B, 14C, 15A, 15B, 16, and 17. More specifically, the (1-1)^{th} surface 3211a of the first surface 3211 of the window 321 in the embodiments of FIGS. 6A, 6B, 7, 8A, 8B, 9, 10A to 10C, 11, 12A, 12B, 13A, 13B, and 14A, 14B, 14C may have a curved shape, while in the embodiment of FIGS. 18A to 18C, the (1-1)^{th} surface 3211a of the first surface 3211 of the window 321 may be formed as an inclined surface (or chamfered surface). In the embodiment of FIGS. 18A to 18C, except for the shape of the (1-1)^{th} surface 3211a of the first surface 3211 of the window 321, the description of the embodiments made above with reference to FIGS. 6A, 6B, 7, 8A, 8B, 9, 10A to 10C, 11, 12A, 12B, 13A, 13B, 14A, 14B, 14C, 15A, 15B, 16, and 17 may be commonly applied, and may not be redundantly described here.

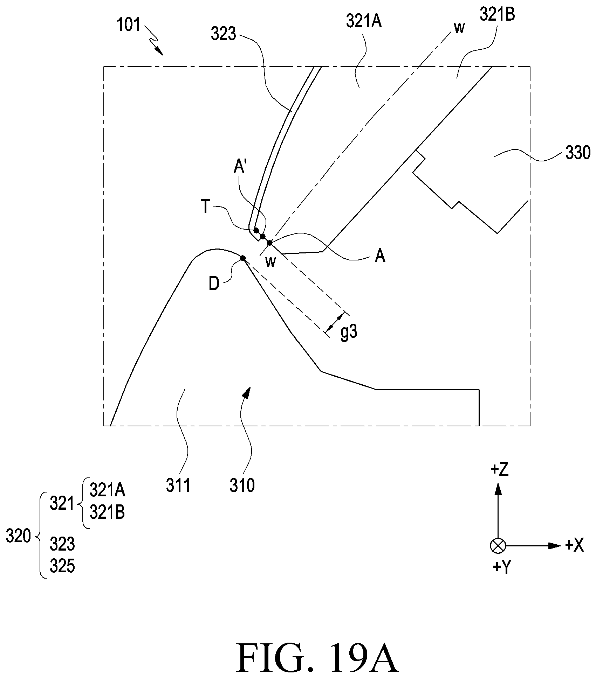

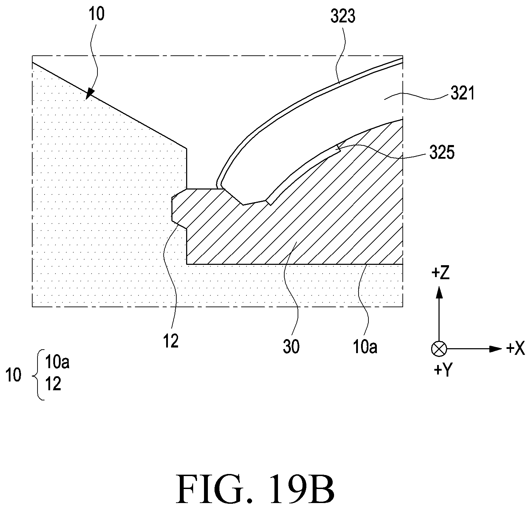

FIG. 19A is a cross-sectional side view of a housing, a window assembly, and a display panel according to an embodiment of the disclosure. FIG. 19B is a cross-sectional side view illustrating a fixing member, an adhesive member, and a window assembly according to an embodiment of the disclosure.

All or part of the configurations of the cover window 321 and the housing 310 in FIGS. 19A and 19B may be the same as or similar to the configuration of the cover window 321 according to the embodiments of FIGS. 6A, 6B, 7, 8A, 8B, 9, 10A to 10C, 11, 12A, 12B, 13A, 13B, 14A, 14B, 14C, 15A, 15B, 16, and 17. The coating layer 323 or the black layer 325 in FIGS. 19A and 19B may be referenced as the coating layer 323 and the black layer 325 according to the embodiments of FIGS. 6A, 6B, 7, 8A, 8B, 9, 10A to 10C, 11, 12A, 12B, 13A, 13B, 14A, 14B, 14C, 15A, 15B, 16, and 17. All or part of the configuration of the fixing member 10 in FIG. 19B may be the same as or similar to the configuration of the fixing member 10 according to the embodiments of FIGS. 11, 12A, 12B, 13A, 13B, and 14A, 14B, and 14C.

The embodiment of FIGS. 19A and 19B may differ in the shape of the window 321 from the embodiments described above with reference to FIGS. 6A, 6B, 7, 8A, 8B, 9, 10A to 10C, 11, 12A, 12B, 13A, 13B, 14A, 14B, 14C, 15A, 15B, 16, and 17. More specifically, the window 321 in FIGS. 19A and 19B may be formed in a 3D shape. According to an embodiment of the disclosure, the surface of the window 321 where the coating layer 323 is formed in FIGS. 19A and 19B may be a curved surface. In the embodiment of FIGS. 19A and 19B, except for the shape of the window 321, the description of the embodiments made above with reference to FIGS. 6A, 6B, 7, 8A, 8B, 9, 10A to 10C, 11, 12A, 12B, 13A, 13B, 14A, 14B, 14C, 15A, 15B, 16, and 17 may be commonly applied, and may not be redundantly described here.

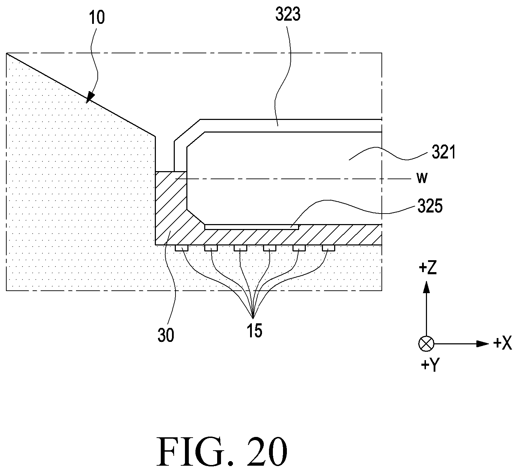

FIG. 20 is a cross-sectional side view illustrating a fixing member, an adhesive member, and a window assembly according to an embodiment of the disclosure.

Referring to FIG. 20, all or part of the configurations of the cover window 321 and the housing 310 in FIG. 20 may be the same as or similar to the configuration of the cover window 321 according to the embodiments of FIGS. 6A, 6B, 7, 8A, 8B, 9, 10A to 10C, 11, 12A, 12B, 13A, 13B, 14A, 14B, 14C, 15A, 15B, 16, 17, and 18A to 18C. The coating layer 323 or the black layer 325 in FIG. 20 may be referenced as the coating layer 323 and the black layer 325 according to the embodiments of FIGS. 6A, 6B, 7, 8A, 8B, 9, 10A to 10C, 11, 12A, 12B, 13A, 13B, 14A, 14B, 14C, 15A, 15B, 16, 17, and 18A to 18C. All or part of the configuration of the fixing member 10 in FIG. 20 may be the same as or similar to the configuration of the fixing member 10 according to the embodiments of FIGS. 11, 12A, 12B, 13A, 13B, and 14A, 14B, and 14C.

Referring to FIG. 20, in an embodiment, the fixing member 10 may include multiple third grooves 15 recessed in the bottom surface (e.g., the +Z direction surface). The third grooves 15 may enhance the coupling strength (or bonding strength) of the fixing member 10 to the adhesive member 30. The third grooves 15 may be spaced apart from each other. However, the layout, shape, and number of the third grooves 15 are not limited. In the embodiment of FIG. 20, the description of the embodiments made above with reference to FIGS. 6A, 6B, 7, 8A, 8B, 9, 10A to 10C, 11, 12A, 12B, 13A, 13B, 14A, 14B, 14C, 15A, 15B, 16, and 17 may be commonly applied, except for the third grooves 15 of the fixing member 10, and may not be redundantly described here.

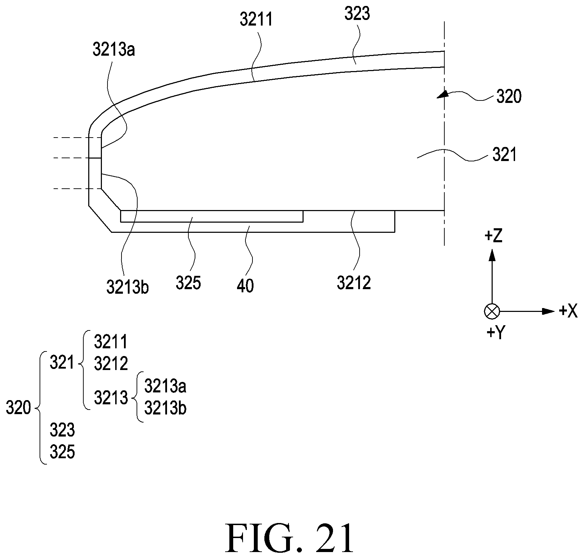

FIG. 21 is a cross-sectional side view illustrating a fixing member, an adhesive member, and a window assembly according to an embodiment of the disclosure.

The cover window 321, the coating layer 323, and the black layer 325 in FIG. 21 may be referenced as the cover window 321, the coating layer 323, and the black layer 325 according to the embodiments of FIGS. 6A, 6B, 7, 8A, 8B, 9, 10A to 10C, 11, 12A, 12B, 13A, 13B, 14A, 14B, 14C, 15A, 15B, 16, 17, 18A, 18B, and 18C.

Referring to FIG. 21, when forming the coating layer 323 on the cover window 321, the coating layer 323 may be applied only to a target area (e.g., the first surface 3211 and a portion of the first edge area 3213a) using the pad member 40. The pad member 40 has adhesive properties and may be attached to the surface of the cover window 321 where the coating layer 323 will not be formed (e.g., the second surface 3212, the second edge area 3213b, and preferably the remaining portion of the first edge area 3213a), and may prevent a coating material from being applied to the attached surface. According to the embodiment of FIG. 21, the use of the adhesive member 30 described above with reference to FIGS. 11, 12A, 12B, 13A, 13B, and 14A, 14B, 14C may be omitted. In the embodiment of FIG. 20, the description of the embodiments made above with reference to FIGS. 6A, 6B, 7, 8A, 8B, 9, 10A to 10C, 11, 12A, 12B, 13A, 13B, 14A, 14B, 14C, 15A, 15B, 16, and 17 may be commonly applied, except for the pad member 40, and may not be redundantly described here.

An electronic device may include a display and a cover window for protecting the display from external physical/chemical impacts. The cover window may be laminated on the front surface of the display and exposed outside the electronic device. One or more coating layers may be provided on the front surface of the cover window to provide functional properties, such as transparency, scratch resistance, and wear resistance. For example, in order to form a coating layer on the cover window, a method of spraying the coating material onto the front surface of the cover window while the cover window is fixed on a jig may be used. In this case, the coating material may overflow from the front surface to the rear surface of the cover window, which may affect the appearance of the cover window and the electronic device. For example, when the coating layer is applied unevenly to the edge area of the cover window, the surface of the coating layer may become uneven, and light reflection may occur in the gap between the cover window and the housing. When the coating layer (e.g., a hard coating layer) has high hardness characteristics, the coating material that has flowed to the rear surface of the cover window may be more likely to break after curing compared to the coating material applied to the front surface. For example, when an external force is applied in the state in which the cover window is assembled, the coating material that has flowed to the rear surface of the window may break when coming into contact with another component (e.g., the housing or the display panel) of the electronic device, which may reduce the reliability of the product.

The aspects of the disclosure are intended to solve at least the aforementioned problems and/or disadvantages and to provide at least the following advantages. According to an embodiment of the disclosure, it is possible to provide a fixing member for a cover window, a method of manufacturing a window assembly using the fixing member, and an electronic device including the window assembly implemented by the manufacturing method. The fixing member used in the manufacturing method may be formed to fix the cover window in place, and the fixing member may be configured such that, when forming the coating layer on the cover window, the coating material is applied only to a target area of the cover window (e.g., the front surface and a portion of the edge surface) and does not flow to the rear surface of the cover window. However, the problems that the disclosure seeks to solve are not limited to the aforementioned problems, and may be expanded in various ways without departing from the spirit and scope of the disclosure.

As described in the embodiments of the disclosure, according to a fixing member for a cover window and a method of manufacturing a window assembly using the same, since a coating layer is formed only on a target area of the cover window and no coating layer is formed on the rear surface of the cover window, the quality of the window assembly can be improved, and the phenomenon of breakage in the window assembly due to a high-hardness coating layer can be reduced when the window assembly is assembled in an electronic device. However, the effects achievable through the disclosure are not limited to those mentioned above, and various effects achievable directly and indirectly through the disclosure may be provided.

A fixing member for a cover window, a method of manufacturing a window assembly using the fixing member, and an electronic device including the window assembly implemented by the manufacturing method according to the disclosure as described above are not limited to the above-described embodiments and drawings, and it will be apparent to those skilled in the art that various substitutions, modifications, and changes are possible within the technical scope of the disclosure.

According to an embodiment of the disclosure, it is possible to provide an electronic device 101. The electronic device may include a housing 210 or 310, a display panel 330 disposed within the housing, a window assembly 302 disposed on one surface of the display panel, wherein an image output from the display panel is provided outside the electronic device through the window assembly. The window assembly may include a cover window 321 including a first surface 3211 exposed outside the electronic device, a second surface 3212 opposite to the first surface, and an edge surface 3213 connecting the first surface and the second surface, and a coating layer 323 disposed on a portion of the cover window. The edge surface of the cover window of the window may include a first edge area 3213a extending from the first surface and a second edge area 3213b extending from the second surface. The coating layer of the window assembly may be disposed on the first surface of the cover window and the first edge area of the edge surface.

According to an embodiment, the cover window may include a neutral plane disposed between the first surface and the second surface, a first portion 321A disposed between the neutral plane and the first surface and configured to resist compressive stress, and a second portion 321B disposed between the neutral plane and the second surface and configured to resist tensile stress.

According to an embodiment, the first edge area and the second edge area of the edge surface may be partially disposed on the first portion of the cover window, and the remaining portion of the second edge area of the edge surface may be disposed on the second portion of the cover window.

According to an embodiment, the coating layer of the window assembly may not be disposed on the second edge area of the edge surface of the cover window.

According to an embodiment, the coating layer may be spaced apart from the second edge area by a predetermined interval.

According to an embodiment, the first surface of the cover window may include a (1-1)^{th} surface (3211a) disposed in a central portion of the first surface and a (1-2)^{th} surface (3211b) disposed at an edge of the first surface and extending between the (1-1)^{th} surface and the first edge area of the edge surface.

According to an embodiment, the (1-1)^{th} surface of the first surface of the cover window may include a flat surface. The (1-2)^{th} surface may include a curved surface.

According to an embodiment, the second surface of the cover window may include a (2-1)^{th} surface disposed in a central portion of the second surface and an inclined (2-2)^{th} surface disposed at an edge of the second surface and extending between the (2-1)^{th} surface and the second edge area of the edge surface.

According to an embodiment, the (2-1)^{th} (3212a) surface of the second surface of the cover window may include a flat surface. The (2-2)^{th} (3212b) surface may be inclined with respect to the (2-1)^{th} surface.

According to an embodiment, the window assembly may further include a black layer 325 disposed on a portion of the second surface.

According to an embodiment, the display panel may include an active area configured to output an image, and an inactive area disposed around the active area where no image is output. The black layer may be disposed to face the inactive area of the display panel.

According to an embodiment, the display panel and the window assembly may be configured to be foldable or rollable.

According to an embodiment, the cover window may include glass, ceramic, synthetic resin, or a combination thereof.

According to an embodiment, the coating layer may include at least one of a hard coating layer, an anti-reflective coating layer, a low-reflective coating layer, or an anti-glare coating layer.

According to an embodiment of the disclosure, it is possible to provide a method of manufacturing a window assembly 302 of an electronic device 101 in operation 20. The manufacturing method may include preparing a cover window 321 in operation 21, introducing an adhesive member 30 to the cover window in operation 22, curing the adhesive member to couple it to the cover window in operation 23, forming a coating layer 323 on a portion of the cover window in operation 24, and removing the cured adhesive member 30 in operation 25.

According to an embodiment, the preparing of the cover window may include forming a basic shape of the cover window, polishing a surface of the cover window, and strengthening the cover window 321.

According to an embodiment, the preparing of the cover window may further include performing pad printing on the strengthened cover window.

According to an embodiment, the introducing of the adhesive member to the cover window may include preparing a fixing member 10 configured such that the cover window is seated thereon, disposing the adhesive member 30 on the fixing member or the cover window, and disposing the cover window on the fixing member with the adhesive member interposed therebetween.

According to an embodiment, the curing of the adhesive member to couple it to the cover window may include curing the adhesive member by applying ultraviolet light, microwaves, infrared light, thermal heating, or a combination thereof.

According to an embodiment, the adhesive member is formed to be water-soluble, and the removing of the cured adhesive member may include immersing the cover window in a solution to remove the adhesive member.

While the disclosure has been described with reference to embodiments, it should be understood that the embodiments are provided for illustrative purpose only and are not intended to limit the disclosure. It will be apparent to those skilled in the art that various changes in form and detail may be made without departing from the overall scope of the disclosure, including the appended claims and their equivalents.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the disclosure and the terms used therein are not intended to limit the technological features set forth herein to particular embodiments and include various changes, equivalents, or replacements for a corresponding embodiment. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

It will be appreciated that various embodiments of the disclosure according to the claims and description in the specification can be realized in the form of hardware, software or a combination of hardware and software.

Any such software may be stored in non-transitory computer readable storage media. The non-transitory computer readable storage media store one or more computer programs (software modules), the one or more computer programs include computer-executable instructions that, when executed by one or more processors of an electronic device, cause the electronic device to perform a method of the disclosure.

Any such software may be stored in the form of volatile or non-volatile storage, such as, for example, a storage device like read only memory (ROM), whether erasable or rewritable or not, or in the form of memory, such as, for example, random access memory (RAM), memory chips, device or integrated circuits or on an optically or magnetically readable medium, such as, for example, a compact disk (CD), digital versatile disc (DVD), magnetic disk or magnetic tape or the like. It will be appreciated that the storage devices and storage media are various embodiments of non-transitory machine-readable storage that are suitable for storing a computer program or computer programs comprising instructions that, when executed, implement various embodiments of the disclosure. Accordingly, various embodiments provide a program comprising code for implementing apparatus or a method as claimed in any one of the claims of this specification and a non-transitory machine-readable storage storing such a program.

While the disclosure has been shown and described with reference to various embodiments thereof, it will be understood by those skilled in the art that various changes in form and details may be made therein without departing from the spirit and scope of the disclosure as defined by the appended claims and their equivalents.

## Claims

1. An electronic device (101) comprising:
a housing (210; 310);
a display panel (330) disposed within the housing; and
a window assembly (302) disposed on one surface of the display panel, wherein an image output from the display panel is provided outside the electronic device through the window assembly,
wherein the window assembly comprises:
a cover window (321) comprising a first surface (3211) exposed outside the electronic device, a second surface (3212) opposite to the first surface, and an edge surface (3213) connecting the first surface and the second surface; and
a coating layer (323) disposed on a portion of the cover window,
wherein the edge surface of the cover window of the window assembly comprises a first edge area (3213a) extending from the first surface and a second edge area (3213b) extending from the second surface, and
wherein the coating layer of the window assembly is disposed on the first surface of the cover window and the first edge area of the edge surface.

2. The electronic device of claim 1, wherein the cover window comprises a neutral plane disposed between the first surface and the second surface, a first portion (321A) disposed between the neutral plane and the first surface and configured to resist compressive stress, and a second portion (321B) disposed between the neutral plane and the second surface and configured to resist tensile stress.

3. The electronic device of claim 2, wherein the first edge area and the second edge area of the edge surface are partially disposed on the first portion of the cover window, and
wherein a remaining portion of the second edge area of the edge surface is disposed on the second portion of the cover window.

4. The electronic device according to claim 2 or 3, wherein the coating layer of the window assembly is not disposed on the second edge area of the edge surface of the cover window.

5. The electronic device of one of claims 1 to 4, wherein the coating layer is spaced apart from the second edge area by a predetermined interval.

6. The electronic device of one of claims 1 to 5, wherein the first surface of the cover window comprises a (1-1)^{th} surface (3211a) disposed in a central portion of the first surface and a (1-2)^{th} surface (3211b) disposed at an edge of the first surface and extending between the (1-1)^{th} surface and the first edge area of the edge surface.

7. The electronic device of claim 6, wherein the (1-1)^{th} surface of the first surface of the cover window comprises a flat surface, and the (1-2)^{th} surface is a curved surface.

8. The electronic device of one of claims 1 to 7, wherein the second surface of the cover window comprises a (2-1)^{th} surface (3212a) disposed in a central portion of the second surface and an inclined (2-2)^{th} surface (3212b) disposed at an edge of the second surface and extending between the (2-1)^{th} surface and the second edge area of the edge surface.

9. The electronic device of claim 8, wherein the (2-1)^{th} surface of the second surface of the cover window comprises a flat surface, and the (2-2)^{th} surface is inclined relative to the (2-1)^{th} surface.

10. The electronic device of one of claims 1 to 9, wherein the window assembly further comprises a black layer (325) disposed on a portion of the second surface.

11. The electronic device of claim 10, wherein the display panel comprises an active area configured to output an image, and an inactive area disposed around the active area where no image is output, and
wherein the black layer is disposed to face the inactive area of the display panel.

12. The electronic device of one of claims 1 to 11, wherein the display panel and the window assembly are configured to be foldable or rollable.

13. The electronic device of one of claims 1 to 12, wherein the cover window comprises glass, ceramic, synthetic resin, or a combination thereof.

14. The electronic device of one of claims 1 to 13, wherein the coating layer comprises at least one of a hard coating layer, an anti-reflective coating layer, a low-reflective coating layer, or an anti-glare coating layer.

15. A method of manufacturing a window assembly (302) of an electronic device (101) (method 20), the method comprising:
preparing a cover window (321) (21);
introducing an adhesive member (30) to the cover window (22);
curing the adhesive member to couple it to the cover window (23);
forming a coating layer (323) on a portion of the cover window (24); and
removing the cured adhesive member (30) (25).
